# EUROPEAN PATENT SPECIFICATION

(11) **EP 2 545 577 B1**
(45) Date of publication and mention of the grant of the patent: **19.09.2018**
(21) Application number: 11753863.7
(22) Date of filing: 07.03.2011
(51) Int. Cl.: H01J 1/62, H01L 33/50, H01L 25/075, H01L 33/48

(54) **WARM WHITE LIGHT EMITTING DEVICE HAVING HIGH COLOR RENDERING INDEX VALUES**
WARMES WEISSLICHT EMITTIERENDE VORRICHTUNG MIT HOHEM FARBDARSTELLUNGSINDEXWERT
DISPOSITIF D'ÉMISSION DE LUMIÈRE BLANCHE CHAUDE AYANT UNE VALEUR D'INDICE DE RENDU DE COULEUR ÉLEVÉE

(30) Priority: 31.01.2011 US 201113017983; 09.03.2010 US 720390
(43) Date of publication of application: 16.01.2013
(73) Proprietor: Cree, Inc., Durham, NC 27703 (US)
(72) Inventor: COLLINS, Brian Thomas, Holly Springs North Carolina 27540 (US); CABALU, Jasper, Apex North Carolina 27523 (US); DONOFRIO, Matthew, Raleigh North Carolina 27613 (US); CANNON, Nathaniel O., Durham North Carolina 27703 (US)
(74) Representative: Boult Wade Tennant LLP
(86) International application number: PCT/US2011/027362
(87) International publication number: WO 2011/112494

(56) References cited:
- WO-A1-2010/023840
- WO-A2-2007/023439
- WO-A2-2007/023439
- US-A1- 2004 256 974
- US-A1- 2004 256 974
- US-A1- 2008 258 602
- US-A1- 2009 179 213
- US-A1- 2009 184 616
- US-A1- 2009 218 581
- US-A1- 2009 283 721

## Description

### CROSS-REFERENCE TO RELATED APPLICATION

This application claims priority under 35 U.S.C. § 120 as a continuation-in-part of U.S. Patent Application No. 12/720,390, filed March 9, 2010.

### BACKGROUND

The present invention relates to light emitting devices and, more particularly, to methods of forming light emitting devices that have high color rendering index ("CRI") values and to light emitting devices that have such high CRI values.

Light emitting diodes ("LEDs") are well known solid state lighting devices that are capable of generating light. LEDs generally include a plurality of semiconductor layers that may be epitaxially grown on a semiconductor or non-semiconductor substrate such as, for example, sapphire, silicon, silicon carbide, gallium nitride or gallium arsenide substrates. One or more semiconductor p-n junctions are formed in these epitaxial layers. When a sufficient voltage is applied across the p-n junction, electrons in the n-type semiconductor layers and holes in the p-type semiconductor layers flow toward the p-n junction. As the electrons and holes flow toward each other, some of the electrons will "collide" with a hole and recombine. Each time this occurs, a photon of light is emitted, which is how LEDs generate light. The wavelength distribution of the light generated by an LED generally depends on the semiconductor materials used and the structure of the thin epitaxial layers that make up the "active region" of the device (i.e., the area where the electrons and holes recombine).

LEDs typically have a narrow wavelength distribution that is tightly centered about a "peak" wavelength (i.e., the single wavelength where the radiometric emission spectrum of the LED reaches its maximum as detected by a photo-detector). For example, the spectral power distributions of a typical LED may have a full width of, for example, about 10-30 nm, where the width is measured at half the maximum illumination (referred to as the full width half maximum or "FWHM" width). Accordingly, LEDs are often identified by their "peak" wavelength or, alternatively, by their "dominant" wavelength. The dominant wavelength of an LED is the wavelength of monochromatic light that has the same apparent color as the light emitted by the LED as perceived by the human eye. Thus, the dominant wavelength differs from the peak wavelength in that the dominant wavelength takes into account the sensitivity of the human eye to different wavelengths of light.

As most LEDs are almost monochromatic light sources that appear to emit light having a single color, LED lamps that include multiple LEDs that emit light of different colors have been used in order to provide solid state light emitting devices that generate white light. In these devices, the different colors of light emitted by the individual LED chips combine to produce a desired intensity and/or color of white light. For example, by simultaneously energizing red, green and blue light emitting LEDs, the resulting combined light may appear white, or nearly white, depending on, for example, the relative intensities, peak wavelength and spectral power distributions of the source red, green and blue LEDs.

White light may also be produced by surrounding a single-color LED with a luminescent material that converts some of the light emitted by the LED to light of other colors. The combination of the light emitted by the single-color LED that passes through the luminescent material along with the light of different colors that is emitted by the luminescent material may produce a white or near-white light. For example, a single blue-emitting LED chip (e.g., made of indium gallium nitride and/or gallium nitride) may be used in combination with a yellow phosphor, polymer or dye such as for example, cerium-doped yttrium aluminum garnet (which has the chemical formula Y₃Al₅O₁₂:Ce, and is commonly referred to as YAG:Ce), that "down-converts" the wavelength of some of the blue light emitted by the LED, changing its color to yellow. Blue LEDs made from indium gallium nitride exhibit high efficiency (e.g., external quantum efficiency as high as 60%). In a blue LED/yellow phosphor lamp, the blue LED chip produces an emission with a dominant wavelength of about 450-460 nanometers, and the phosphor produces yellow fluorescence with a peak wavelength of about 550 nanometers in response to the blue emission. Some of the blue light passes through the phosphor (and/or between the phosphor particles) without being down-converted, while a substantial portion of the light is absorbed by the phosphor, which becomes excited and emits yellow light (i.e., the blue light is down-converted to yellow light). The combination of blue light and yellow light may appear white to an observer. Such light is typically perceived as being cool white in color. In another approach, light from a violet or ultraviolet emitting LED may be converted to white light by surrounding the LED with multicolor phosphors or dyes. In either case, red-emitting phosphor particles (e.g., a CaAlSiN3 ("CASN") based phosphor) may also be added to improve the color rendering properties of the light, *i.e.,* to make the light appear more "warm," particularly when the single color LED emits blue or ultraviolet light.

As noted above, phosphors are one known class of luminescent materials. A phosphor may refer to any material that absorbs light at one wavelength and re-emits light at a different wavelength in the visible spectrum, regardless of the delay between absorption and re-emission and regardless of the wavelengths involved. Accordingly, the term "phosphor" may be used herein to refer to materials that are sometimes called fluorescent and/or phosphorescent. In general, phosphors may absorb light having first wavelengths and re-emit light having second wavelengths that are different from the first wavelengths. For example, "down-conversion" phosphors may absorb light having shorter wavelengths and re-emit light having longer wavelengths.

LEDs have been combined with phosphor layers by dispensing phosphor-containing encapsulant material (e.g., epoxy resin or silicone) over the LED to cover the LED. However, it can be difficult to control the geometry and/or thickness of the phosphor layer. As a result, light emitted from the LED at different angles can pass through different amounts of luminescent material, which can result in an LED with non-uniform color temperature as a function of viewing angle. Because the geometry and thickness is hard to control, it can also be difficult to consistently reproduce LEDs with the same or similar emission characteristics.

Another conventional method for coating a phosphor layer onto an LED is by stencil printing. In a stencil printing approach, multiple LEDs are arranged on a substrate with a desired distance between adjacent LEDs. A stencil is provided having openings that align with the LEDs, with the holes being slightly larger than the LEDs and the stencil being thicker than the LEDs. The stencil is positioned on the substrate with each of the LEDs located within a respective one of the openings in the stencil. A composition is then deposited in the stencil openings, covering the LEDs, with a typical composition being a phosphor in a silicone polymer that can be cured by heat or light. After the holes are filled, the stencil is removed from the substrate and the stenciling composition is cured to a solid state.

Like the volumetric dispense method described above, the stenciling method may also present difficulties in controlling the geometry and/or layer thickness of the phosphor containing polymer. The stenciling composition may not fully fill the stencil opening, resulting in non-uniform layers. The phosphor-containing composition can also stick to the stencil opening, which may reduce the amount of composition remaining on the LED. These problems can result in LEDs having non-uniform color temperature and LEDs that are difficult to consistently reproduce with the same or similar emission characteristics.

Another conventional method for coating LEDs with a phosphor utilizes electrophoretic deposition (EPD). The phosphor particles are suspended in an electrolyte based solution. A plurality of LEDs are immersed in the electrolyte solution. One electrode from a power source is coupled to the LEDs, and the other electrode is arranged in the electrolyte solution. The bias from the power source is applied across the electrodes, which causes current to pass through the solution to the LEDs. This creates an electric field that causes the phosphor particles to be drawn to the LEDs, covering the LEDs with the conversion material.

After the LEDs are covered by the phosphor particles, they are removed from the electrolyte solution so that the LEDs and their phosphor particles can be covered by a protective resin. This adds an additional step to the process and the phosphor particles can be disturbed prior to the application of the resin. During the deposition process, the electric field in the electrolyte solution can also vary such that different concentrations of phosphor particles can be deposited across the LEDs. Additionally, the electric field in the electrolyte solution may act preferentially according to particle size thereby increasing the difficulty of depositing mixed phosphors of different particle sizes. The phosphor particles can also settle in the solution, which can also result in different phosphor particle concentrations across the LEDs. The electrolyte solution can be stirred to prevent settling, but this presents the danger of disturbing the particles already on the LEDs.

Still another coating method for LEDs utilizes droplet deposition using systems similar to those in an ink-jet printing apparatus. Droplets of a liquid phosphor-containing material are sprayed from a print head. The phosphor-containing droplets are ejected from a nozzle on the print head in response to pressure generated in the print head by a thermal bubble and/or by piezoelectric crystal vibrations. However, in order to control the flow of the phosphor-containing composition from the ink-jet print head, it may be necessary for the print head nozzle to be relatively small. In fact, it may be desirable to engineer the size and/or shape of the phosphor particles to prevent them from catching in the nozzle and clogging the print head.

LEDs are used in a host of applications including, for example, backlighting for liquid crystal displays, indicator lights, automotive headlights, flashlights, specialty lighting applications and even as replacements for conventional incandescent and/or fluorescent lighting in general lighting and illumination applications. In many of these applications, it may be desirable to use phosphors or other luminophoric mediums to provide a lighting source that generates light having specific properties. It may also be desirable to apply the phosphors or other luminophoric mediums to such lighting sources so that they have good conformity and/or uniformity.

Prior art documents US 2004/256974 A1, WO 2007/023439 A2, WO 2010/023840 A1 and US 2008/258602 disclose light emitting devices which are coated with a plurality of different phosphor materials.

### SUMMARY

The present disclosure comprises embodiments, some of which are embodiments of the invention as defined by the appended claims. Pursuant to some embodiments of the present invention, methods of forming light emitting devices are provided in which a solid state lighting source is heated. A luminescent solution is then applied to the heated solid state lighting source to form the light emitting device. The luminescent solution includes a first material that down-converts the radiation emitted by the solid state lighting source to radiation that has a peak wavelength in the green color range and that has a full width half maximum emission bandwidth that extends into the cyan color range, and at least one additional material that down-converts the radiation emitted by the solid state lighting source to radiation having a peak wavelength in another color range

In some embodiments, the luminescent solution may be applied to the solid state lighting source while the solid state lighting source is at a temperature of at least about 90 degrees Celsius. In some embodiments, the method further involves curing the luminescent solution to provide a recipient luminophoric medium on the solid state lighting source. The luminescent solution may include a binder material and/or a solvent. The curing of the luminescent solution may evaporate at least some of the solvent.

In some embodiments, the first material may be a first phosphor that down-converts the radiation emitted by the solid state lighting source to a radiation having a peak wavelength between 525 nanometers and 550 nanometers, and that has a full width half maximum emission bandwidth that extends below 500 nanometers. The at least one additional material may be a second phosphor and a third phosphor which together down-convert the radiation emitted by the solid state lighting source to a radiation having at least one peak wavelength greater than 580 nanometers. In some embodiments, the second phosphor may down-convert the radiation emitted by the solid state lighting source to a radiation having a peak wavelength between 530 nanometers and 585 nanometers, and the third phosphor may down-convert the radiation emitted by the solid state lighting source to a radiation having a peak wavelength between 600 nanometers and 660 nanometers.

In some embodiments, the solid state lighting source may be a light emitting diode that emits light having a dominant wavelength in the blue color range, and the light emitting device may emit a warm white light having a correlated color temperature between about 2500K and 4500K and has a CRI value of at least 90. The luminescent solution may be wavelength conversion particles that are suspended in a solution that includes a volatile solvent and a binder material. The volatile solvent may be evaporated via thermal energy in the heated solid state lighting source. In other embodiments, the luminescent solution may be wavelength conversion particles suspended in a solution including a nonvolatile solvent and a binder material. In such embodiments, the nonvolatile solvent and/or binder may be cured via thermal energy in the heated solid state lighting source.

In some embodiments, the solid state lighting source may be a singulated light emitting diode having a top surface and a wirebond pad on the top surface. A wire may be bonded to the wirebond pad before heating the singulated light emitting diode. In other embodiments, the solid state lighting source may be a light emitting diode wafer. This wafer may be singulated into a plurality of light emitting diode chips after the luminescent solution is applied thereto. In some embodiments, the luminescent solution may be applied to the heated solid state lighting source by spraying a layer of a first atomized luminescent solution onto the heated solid state lighting source, then curing the layer of the first atomized luminescent solution, and then spraying a layer of a second atomized luminescent solution onto the cured layer of the first atomized luminescent solution.

In some embodiments, the first phosphor may be a first aluminum garnet-based phosphor, the second phosphor may be a second aluminum garnet-based phosphor, and the third phosphor may be a nitride- or oxynitride-based phosphor. In some embodiments, the first phosphor may be a cerium activated phosphor, the second phosphor may be a cerium activated phosphor, and the third phosphor may be a europium activated phosphor.

Pursuant to further embodiments of the present invention, light emitting devices are provided that include a light emitting diode ("LED") that emits light having a dominant wavelength in the blue color range and a conformal recipient luminophoric medium that is configured to down-convert at least some of the light emitted by the LED. The recipient luminophoric medium includes at least a first phosphor that down-converts the radiation emitted by the LED to radiation having a peak wavelength in the green color range, a second phosphor that down-converts the radiation emitted by the LED to radiation having a peak wavelength in a second color range having wavelengths above the green color range, a third phosphor that down-converts the radiation emitted by the LED to radiation having a peak wavelength in a third color range having wavelengths above the green color range, and a binder material that is cured by heat energy in the LED at the time the conformal recipient luminophoric medium layer is applied to the LED,

In some embodiments, the first phosphor has a full width half maximum emission bandwidth that extends into the cyan color range. The second phosphor may down-convert the radiation emitted by the LED to radiation having a peak wavelength in the yellow color range, and the third phosphor may down-convert the radiation emitted by the LED to radiation having a peak wavelength in the red color range. The phosphors included in the recipient luminophoric medium and the LED may be configured to together emit warm white light having a correlated color temperature between about 2500K and 3300K and having a CRI of at least 90. The first phosphor may be a LuAG:Ce phosphor, and the dominant wavelength of the LED is between about 460 nanometers and 470 nanometers. The conformal recipient luminophoric medium may include a first conformal recipient luminophoric medium layer that is directly on the LED and a second conformal recipient luminophoric medium layer that is on the first conformal recipient luminophoric medium layer, where at least one of the first conformal recipient luminophoric medium layer and the second conformal recipient luminophoric medium layer includes light diffuser particles. The light emitting devices according to various embodiments of the present invention may be designed to provide a warm white light having a high color rendering index.

Pursuant to still further embodiments of the present invention, packaged light emitting devices are provided that include a submount, an LED mounted on the submount, and a recipient luminophoric medium conformally coated on the LED and on the submount. This recipient luminophoric medium includes at least a first material that down-converts the radiation emitted by the LED to radiation having a first peak wavelength, a second material that down-converts the radiation emitted by the LED to radiation having a second peak wavelength, and a third material that down-converts the radiation emitted by the LED to radiation having a third peak wavelength.

In some embodiments, the LED emits light having a dominant wavelength in the blue color range, and the first material down-converts the radiation emitted by the LED to radiation having a peak wavelength in the green color range that has a full width half maximum emission bandwidth that extends into the cyan color range, The second material may down-convert the radiation emitted by the LED to radiation having a peak wavelength in the yellow color range. The third material may down-convert the radiation emitted by the LED to radiation having a peak wavelength in the red color range. In some embodiments, the packaged light emitting device further includes comprising an additional LED that is mounted on the submount. The additional LED may emit light having a dominant wavelength in, for example, the red color range or the blue color range.

Pursuant to still further embodiments of the present invention, packaged light emitting devices are provided that include a submount, an LED mounted on the submount, and a recipient luminophoric medium conformally coated on the LED and on the submount. The recipient luminophoric medium may include a first material that down-converts the radiation emitted by the LED to radiation having a peak wavelength in the green color range that has a full width half maximum emission bandwidth that extends into the cyan color range and a second material that down-converts the radiation emitted by the LED to radiation having a second peak wavelength in a color range having wavelengths above the green color range.

Pursuant to yet additional embodiments of the present invention, packaged LEDs are provided that include a submount, at least two LEDs that emit light having a dominant wavelength in the blue color range mounted on the submount, and a conformal recipient luminophoric medium that is mounted to receive light emitted by the at least two blue LEDs. The conformal recipient luminophoric medium may include a first phosphor that down-converts the radiation emitted by the at least two blue LEDs to radiation having a peak wavelength in the green color range that has a full width half maximum emission bandwidth that extends into the cyan color range and a second phosphor that down-converts the radiation emitted by the at least two blue LEDs to radiation having a peak wavelength in a second color range having wavelengths above the green color range. In some embodiments, the second phosphor may down-convert the radiation emitted by the at least two blue LEDs to radiation having a peak wavelength in the yellow color range, and the conformal recipient luminophoric medium may further include a third phosphor that down-converts the radiation emitted by the at least two blue LEDs to radiation having a peak wavelength in the red color range.

Pursuant to additional embodiments of the present invention, methods of forming a packaged LED are provided in which an LED is mounted on a submount. A luminescent solution is prepared that includes at least a first material that down-converts the radiation emitted by the LED to radiation having a first peak wavelength, a second material that down-converts the radiation emitted by the LED to radiation having a second peak wavelength, and a third material that down-converts the radiation emitted by the LED to radiation having a third peak wavelength. This luminescent solution is then conformally coated onto the LED and on the submount.

In some embodiments, the luminescent solution is sprayed onto the LED and on the submount. In some embodiments, the LED is heated such that the LED is at a temperature of at least about 90 degrees Celsius when the luminescent solution is sprayed onto the LED. The heat from the heated LED may cure the luminescent saolution to form a conformal recipient luminophoric medium on the LED.

### BRIEF DESCRIPTION OF THE DRAWINGS

**FIG. 1** is a graph of a 1931 CIE Chromaticity Diagram illustrating the location of the planckian locus.
**FIG. 2** is a graph illustrating the intensity of the radiation emitted by a conventional warm white solid state lighting device as a function of wavelength.
**FIG. 3** is a graph illustrating the intensity of the radiation emitted, as a function of wavelength, by three warm white solid state lighting devices that use blue LEDs having different dominant wavelengths.
**FIG. 4** is a graph illustrating the intensity of the radiation emitted by three different solid state lighting devices according to embodiments of the present invention as a function of the wavelength.
**FIG. 5A** is a chart that illustrates the median CRI for a plurality of solid state light emitting devices according to embodiments of the present invention as compared to the median CRI for a plurality of conventional solid state light emitting devices.
**FIG. 5B** is a chart that illustrates the median luminous flux for the devices used to generate **FIG. 5A****.**
**FIG. 6A** is a chart that illustrates the measured CRI for a plurality of conventional solid state light emitting devices and for a plurality of solid state light emitting devices according to embodiments of the present invention.
**FIG. 6B** is a graph of the data from the chart of **FIG. 6A****.**
**FIG. 7A** is a graph that illustrates the median CRI for various solid state light emitting devices as a function of the dominant wavelength of the blue LEDs included in the devices.
**FIG. 7B** is a graph that illustrates the luminous flux of the solid state light emitting devices of **FIG. 7A** as a percentage of the luminous flux of conventional solid state light emitting devices with blue LEDs having the same dominant wavelengths.
**FIGS. 8A-8D** are various views of a solid state light emitting device according to embodiments of the present invention.
**FIGS. 9A-9D** are various views of a packaged light emitting device that includes multiple LED chips according to embodiments of the present invention.
**FIGS. 10A-10D** are various views of another packaged light emitting device that includes multiple LED chips according to embodiments of the present invention.
**FIGS. 11A-11C** are various views of yet another packaged light emitting device that includes multiple LED chips according to embodiments of the present invention.
**FIGS. 12A-12E** are sectional views illustrating fabrication steps that may be used to apply a luminophoric medium to an LED chip wafer according to certain embodiments of the present invention,
**FIG. 13** is a flowchart illustrating operations for applying a recipient luminophoric medium to an LED chip wafer according to further embodiments of the present invention.
**FIGS. 14A-14L** are a series of schematic diagrams that illustrate the application of a recipient luminophoric medium to a light emitting device according to some embodiments of the present invention.
**FIGS. 15A-15B** illustrate the application of a recipient luminophoric medium according to some embodiments of the present invention.
**FIG. 16** is a flowchart illustrating operations according to some embodiments of the present invention.
**FIG. 17** is a schematic diagram illustrating a pressurized deposition system for depositing a recipient luminophoric medium according to some embodiments of the present invention.
**FIG. 18** is a schematic diagram that illustrates a spray nozzle according to embodiments of the invention.
**FIG. 19** is a schematic diagram illustrating a batch deposition system for depositing a recipient luminophoric medium on a light emitting device according to some embodiments of the invention.
**FIGS. 20A-20C** are schematic diagrams that illustrate the application of a recipient luminophoric medium to a wafer according to some embodiments of the present invention.

### DETAILED DESCRIPTION

The present invention now will be described more fully hereinafter with reference to the accompanying drawings, in which embodiments of the invention are shown. However, this invention should not be construed as limited to the embodiments set forth herein. Rather, these embodiments are provided so that this disclosure will be thorough and complete, and will fully convey the scope of the invention to those skilled in the art. In the drawings, the thickness of layers and regions are exaggerated for clarity. Like numbers refer to like elements throughout. As used herein the term "and/or" includes any and all combinations of one or more of the associated listed items.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that, when used in this specification, the terms "comprises" and/or "including" and derivatives thereof, specify the presence of stated features, operations, elements, and/or components, but do not preclude the presence or addition of one or more other features, operations, elements, components, and/or groups thereof.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

It will be understood that, although the terms first, second, etc. may be used herein to describe various elements, components, regions and/or layers, these elements, components, regions and/or layers should not be limited by these terms. These terms are only used to distinguish one element, component, region or layer from another element, component, region or layer. Thus, a first element, component, region or layer discussed below could be termed a second element, component, region or layer without departing from the teachings of the present invention.

Furthermore, relative terms, such as "lower" or "bottom" and "upper" or "top," may be used herein to describe one element's relationship to another element as illustrated in the figures. It will be understood that relative terms are intended to encompass different orientations of the device in addition to the orientation depicted in the figures. For example, if the device in the figures is turned over, elements described as being on the "lower" side of other elements would then be oriented on "upper" sides of the other elements. The exemplary term "lower", can therefore, encompasses both an orientation of "lower" and "upper," depending on the particular orientation of the figure.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of this specification and the relevant art and will not be interpreted in an idealized or overly formal sense unless expressly so defined herein.

Embodiments of the invention are described herein with reference to cross-section illustrations that are schematic illustrations of idealized embodiments (and intermediate structures) of the invention. The thickness of layers and regions in the drawings may be exaggerated for clarity. Additionally, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

As used herein, the term "solid state light emitting device" may include a light emitting diode, laser diode and/or other semiconductor device which includes one or more semiconductor layers, which may include silicon, silicon carbide, gallium nitride and/or other semiconductor materials, an optional substrate which may include sapphire, silicon, silicon carbide and/or other microelectronic substrates, and one or more contact layers which may include metal and/or other conductive materials. The design and fabrication of solid state light emitting devices are well known to those skilled in the art. The expression "light emitting device," as used herein, is not limited, except that it be a device that is capable of emitting light.

Solid state light emitting devices according to embodiments of the invention may include III-V nitride (e.g., gallium nitride) based LEDs or lasers fabricated on a silicon carbide, sapphire or gallium nitride substrates such as those devices manufactured and/or sold by Cree, Inc. of Durham, N.C. Such LEDs and/or lasers may (or may not) be configured to operate such that light emission occurs through the substrate in a so-called "flip chip" orientation. Solid state light emitting devices according to embodiments of the present invention include both vertical devices with a cathode contact on one side of the chip, and an anode contact on an opposite side of the chip and devices in which both contacts are on the same side of the device. Some embodiments of the present invention may use solid state light emitting devices, device packages, fixtures, luminescent materials/elements, power supplies, control elements, and/or methods such as described in U.S. Patent Nos. 7,564,180; 7,456,499; 7,213,940; 7,095,056; 6,958,497; 6,853,010; 6,791,119; 6,600,175, 6,201,262; 6,187,606; 6,120,600; 5,912,477; 5,739,554; 5,631,190; 5,604,135; 5,523,589; 5,416,342; 5,393,993; 5,359,345; 5,338,944; 5,210,051; 5,027,168; 5,027,168; 4,966,862, and/or 4,918,497, and U.S. Patent Application Publication Nos. 2009/0184616; 2009/0080185; 2009/0050908; 2009/0050907; 2008/0308825; 2008/0198112; 2008/0179611, 2008/0173884, 2008/0121921; 2008/0012036; 2007/0253209; 2007/0223219; 2007/0170447; 2007/0158668; 2007/0139923, and/or 2006/0221272.

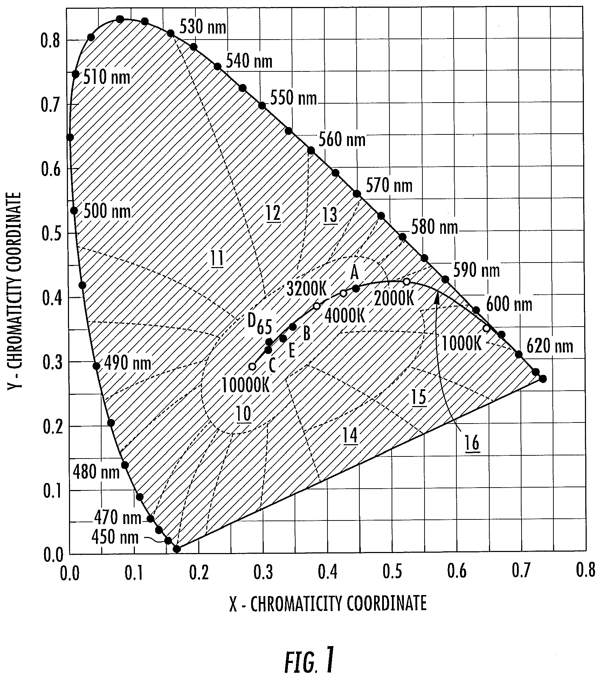

Visible light may include light having many different wavelengths. The apparent color of visible light can be illustrated with reference to a two-dimensional chromaticity diagram, such as the 1931 CIE Chromaticity Diagram illustrated in **FIG. 1****.** Chromaticity diagrams provide a useful reference for defining colors as weighted sums of colors.

As shown in **FIG. 1****,** colors on a 1931 CIE Chromaticity Diagram are defined by x and y coordinates (i.e., chromaticity coordinates, or color points) that fall within a generally U-shaped area. Colors on or near the outside of the area are saturated colors composed of light having a single wavelength, or a very small wavelength distribution. Colors on the interior of the area are unsaturated colors that are composed of a mixture of different wavelengths. White light, which can be a mixture of many different wavelengths, is generally found near the middle of the diagram, in the region labeled **10** in **FIG. 1****.** There are many different hues of light that may be considered "white," as evidenced by the size of the region **10.** For example, some "white" light, such as light generated by sodium vapor lighting devices, may appear yellowish in color, while other "white" light, such as light generated by some fluorescent lighting devices, may appear more bluish in color.

Light that generally appears green or includes a substantial green component is plotted in the regions **11, 12** and **13** that are above the white region **10,** while light below the white region **10** generally appears pink, purple or magenta. For example, light plotted in regions **14** and **15** of **FIG. 1** generally appears magenta (i.e., red-purple or purplish red).

It is further known that a binary combination of light from two different light sources may appear to have a different color than either of the two constituent colors. The color of the combined light may depend on the wavelengths and relative intensities of the two light sources. For example, light emitted by a combination of a blue source and a red source may appear purple or magenta to an observer. Similarly, light emitted by a combination of a blue source and a yellow source may appear white to an observer.

Each point in the graph of **FIG. 1** is referred to as the "color point" of a light source that emits a light having that color. As shown in **FIG. 1** a locus of color points that is referred to as the "black-body" locus **16** exists which corresponds to the location of color points of light emitted by a black-body radiator that is heated to various temperatures. The black-body locus **16** is also referred to as the "planckian" locus because the chromaticity coordinates (i.e., color points) that lie along the black-body locus obey Planck's equation: E(λ)=Aλ⁻⁵/(e^{B/T}-1), where E is the emission intensity, λ is the emission wavelength, T is the color temperature of the black-body and A and B are constants. Color coordinates that lie on or near the black-body locus **16** yield pleasing white light to a human observer.

As a heated object becomes incandescent, it first glows reddish, then yellowish, then white, and finally bluish, as the wavelength associated with the peak radiation of the black-body radiator becomes progressively shorter with increased temperature. This occurs because the wavelength associated with the peak radiation of the black-body radiator becomes progressively shorter with increased temperature, consistent with the Wien Displacement Law. Illuminants that produce light which is on or near the black-body locus **16** can thus be described in terms of their correlated color temperature (CCT). As used herein, the term "white light" refers to light that is perceived as white, is within 7 MacAdam ellipses of the black-body locus on a 1931 CIE chromaticity diagram, and has a CCT ranging from 2000K to 10,000K. White light with a CCT of 4000K may appear yellowish in color, while white light with a CCT of 8000K or more may appear more bluish in color, and may be referred to as "cool" white light. "Warm" white light may be used to describe white light with a CCT of between about 2500K and 4500K, which is more reddish or yellowish in color. Warm white light is generally a pleasing color to a human observer. Warm white light with a CCT of 2500K to 3300K may be preferred for certain applications.

The ability of a light source to accurately reproduce color in illuminated objects is typically characterized using the color rendering index ("CRI"). The CRI of a light source is a modified average of the relative measurements of how the color rendition of an illumination system compares to that of a reference black-body radiator when illuminating eight reference colors. Thus, the CRI is a relative measure of the shift in surface color of an object when lit by a particular lamp. The CRI equals 100 if the color coordinates of a set of test colors being illuminated by the illumination system are the same as the coordinates of the same test colors being irradiated by the black-body radiator. Daylight generally has a CRI of nearly 100, incandescent bulbs have a CRI of about 95, fluorescent lighting typically has a CRI of about 70 to 85, while monochromatic light sources have a CRI of essentially zero. Light sources for general illumination applications with a CRI of less than 50 are generally considered very poor and are typically only used in applications where economic issues preclude other alternatives. Light sources with a CRI value between 70 and 80 have application for general illumination where the colors of objects are not important. For some general interior illumination, a CRI value of greater than 80 is acceptable. A light source with color coordinates within 4 MacAdam step ellipses of the planckian locus **16** and a CRI value that exceeds 85 is more suitable for general illumination purposes. Light sources with CRI values of more than 90 provide greater color quality.

For backlight, general illumination and various other applications, it is often desirable to provide a lighting source that generates white light having a relatively high CRI, so that objects illuminated by the lighting source may appear to have more natural coloring to the human eye. Accordingly, such lighting sources may typically include an array of solid state lighting devices including red, green and blue light emitting devices. When red, green and blue light emitting devices are energized simultaneously, the resulting combined light may appear white, or nearly white, depending on the relative intensities of the red, green and blue sources. However, even light that is a combination of red, green and blue emitters may have a low CRI, particularly if the emitters generate saturated light, because such light may lack contributions from many visible wavelengths.

According to some embodiments of the present invention, LEDs and other solid state light emitting devices are provided that emit warm white light having high CRI values. Solid state lighting devices according to embodiments of the present invention may emit light having CRI values that exceed 90 and may have a color point that is within 7 MacAdam ellipses of the black-body locus on a 1931 CIE chromaticity diagram and that has a correlated color temperature of between about 2500K and about 4500K. In other embodiments, the solid state lighting devices may emit light having CRI values that exceed 90 and may have a color point that is between 0.385 and 0.485 ccx and 0.380 and 0.435 ccy on the 1931 CIE chromaticity diagram and may have a correlated color temperature of between about 2500K and about 4500K. In some embodiments, the correlated color temperature is between about 2500K and about 3300K. The LEDs according to embodiments of the present invention may achieve these high CRI values and warm white light output with a relatively high luminous flux as compared to conventional single-die LEDs that use a comparable LED and have a comparable color point, as such conventional LEDs typically have either lower CRI values or reduced luminous flux.

The LEDs according to some embodiments of the present invention use luminophoric mediums to provide warm white light having the high CRI value. Herein, the term "luminophoric medium" refers to a medium which includes one or more luminescent materials such as, for example, phosphors. A wide variety of luminescent materials are known, with exemplary materials being disclosed in, for example, U.S. Patent No. 6,600,175 and U.S. Patent Application Publication No. 2009/0184616. In addition to phosphors, other luminescent materials include scintillators, day glow tapes, nanophosphors, quantum dots, and inks that glow in the visible spectrum upon illumination with (e.g., ultraviolet) light. Exemplary luminophoric mediums include layers that include luminescent materials that are coated on solid state light emitting devices and clear encapsulents (e.g., epoxy-based or silicone-based curable resin) that include luminescent materials that are arranged to partially or fully cover one or more solid state light emitting devices.

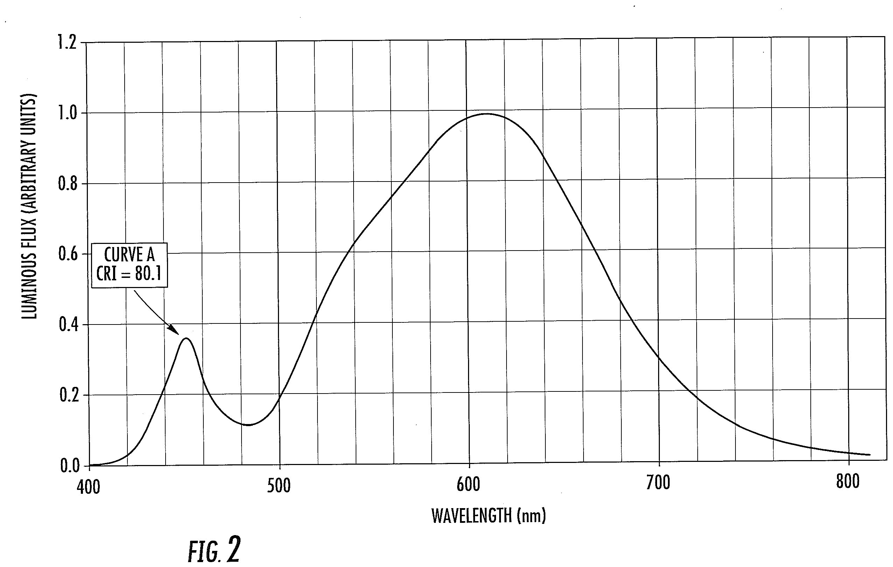

Currently, single-die solid state lighting devices are available that comprise an LED that emits radiation having a dominant wavelength in the blue color range (e.g., radiation with a dominant wavelength of 465 nanometers). A luminophoric medium is coated or placed on, above and/or around the die, or otherwise arranged to receive the blue light emitted by the LED (herein a luminophoric medium that is arranged to receive the light emitted by a solid state lighting source such as an LED is referred to as a "recipient luminophoric medium"). The recipient luminophoric medium comprises an encapsulant material such as, for example, silicone that has YAG:Ce phosphor particles and (Ca₁₋ₓSrₓ)SiAlN₃:Eu²⁺ phosphor particles suspended therein. The YAG:Ce phosphor particles down-convert blue light received from the LED to yellow light, and the (Ca₁₋ₓSrₓ)SiAlN₃:Eu²⁺ phosphor particles down-convert the blue light received from the LED to red light. **FIG. 2** is a graph illustrating the intensity of the radiation emitted by such a solid state lighting device as a function of wavelength. The exemplary device used to generate the graph of **FIG. 2** uses a blue LED having a dominant wavelength of 456 nanometers, and produces a warm white light having a CRI of 80,1. The light from the blue LED that passes through (or around) the luminophoric medium without being down-converted generates the narrow peak in Curve A of **FIG. 2** at 456 nanometers. The light from the blue LED that is down-converted by the yellow and red phosphors generates the broad peak in Curve A of **FIG. 2** at just over 600 nanometers. Herein, single-die solid state lighting devices that include recipient luminophoric mediums that have a yellow phosphor and a red phosphor such as the device used to generate the graph of **FIG. 2** are referred to as yellow/red phosphor devices.

Single-die solid state lighting devices are also currently available that comprise an LED that emits radiation having a dominant wavelength in the blue color range that have a recipient luminophoric silicone encapsulent material that includes phosphor particles that down-convert the blue light received from the LED to green light, and phosphor particles that down-convert the blue light received from the LED to red light. These devices produce a warm white light having a significantly higher CRI value such as, for example, a CRI between 84-94. Herein these devices are referred to as green/red phosphor devices. However, because phosphors that emit light having a peak wavelength in the green color range may be less efficient than various other phosphors, the green/red phosphor devices may have luminous flux values that are significantly lower (e.g., 25-30% or more) than the luminous flux values of a comparable yellow/red phosphor devices.

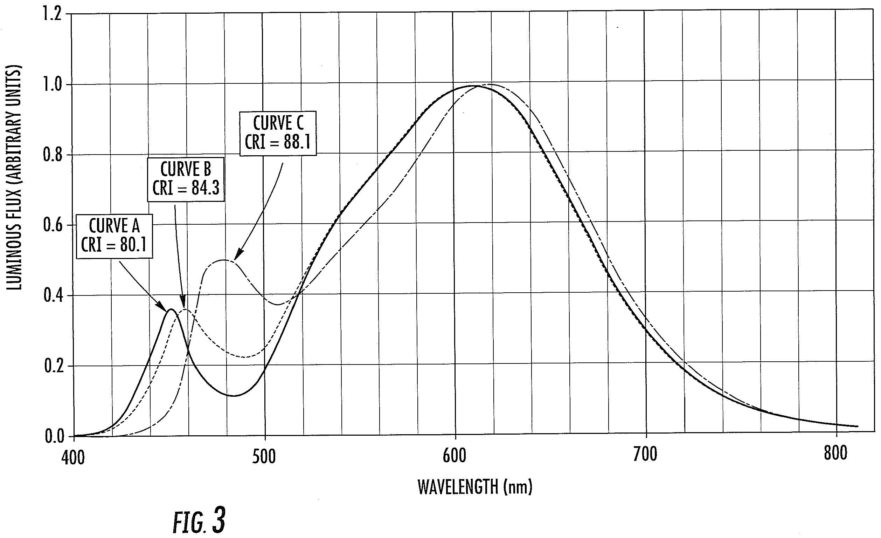

In order to increase the CRI value of the conventional yellow/red phosphor devices, the dominant wavelength of the blue LED that is included in the devices was increased. In particular, **FIG. 3** is a graph illustrating the intensity of the radiation emitted by three different yellow/red phosphor devices, where the only difference between the three devices is the dominant wavelength of the blue LED included therein.

In **FIG. 3****,** Curve A illustrates the output of a solid state light emitting device that has a blue LED with a dominant wavelength of 456 nanometers (Curve A is identical to Curve A in the graph of **FIG. 2**). Curve B illustrates the output of a solid state light emitting device that has a blue LED with a dominant wavelength of 464 nanometers, and Curve C illustrates the output of a solid state device that has a blue LED with a dominant wavelength of 472 nanometers. In the devices used to generate Curves A-C, the ratio of the yellow phosphor to the red phosphor was varied so that each of the devices would produce a light having a color that was at approximately the same location on the 1931 CIE Chromaticity Diagram illustrated in **FIG. 1****.** In particular, as the dominant wavelength of the light emitted by the blue LED was increased, the ratio of yellow to red phosphors was changed to include more red phosphor and less yellow phosphor. Thus, the recipient luminophoric medium of the device used to generate Curve B had a higher ratio of red-to-yellow phosphors than did the recipient luminophoric medium of the device used to generate Curve A, and the recipient luminophoric medium of the device used to generate Curve C had a higher ratio of red-to-yellow phosphors than did the recipient luminophoric medium of the device used to generate Curve B.

For each of Curves A-C, the y-axis represents the normalized luminous flux of the device, where the luminous flux at each wavelength is graphed as a percentage of the luminous flux at the peak emission wavelength for that particular curve. Accordingly, **FIG. 3** shows the relative intensity of the luminous flux as a function of wavelength for each device, but does not illustrate the relative luminous flux values between the three devices.

As shown in Curves A and B of **FIG. 3****,** when the dominant wavelength of the blue LED is increased from 456 nanometers (Curve A) to 464 nanometers (Curve B), the percentage of the luminous flux in the cyan color range (the cyan color range is defined herein as light having a peak wavelength between about 480 nanometers and 500 nanometers) is increased as compared to the device that includes the 456 nanometer blue LED. As is also shown in **FIG. 3****,** this change increased the CRI of the device from 80.1 for the device of Curve A to 84.3 for the device of Curve B.

As shown in Curve C of **FIG. 3****,** when the dominant wavelength of the blue LED is further increased to 472 nanometers, the percentage of the luminous flux in the cyan color range is further increased, as the dominant wavelength of the blue LED is now just outside the cyan color range. Thus, with the device that was used to generate Curve C of **FIG. 3****,** the luminous flux in the cyan range is on the order of half the luminous flux at the peak of the light emitted by the combination of red and yellow phosphors, whereas with the device used to generate Curve A, the luminous flux in the cyan range is on the order of only 10-20% of the luminous flux at the peak of the light emitted by the combination of the red and yellow phosphors. As is further shown in **FIG. 3****,** by further shifting the dominant wavelength of the blue LED to 472 nanometers, the CRI of the device is further increased to 88.1.

While the device of Curve C of **FIG. 3** exhibits improved CRI, there are applications where single die warm white LEDs are desired that have CRI values of greater than 90. Pursuant to embodiments of the present invention, single die solid state light emitting devices are provided that emit warm white light and have relatively high CRI values such as, for example, CRI values that may exceed 90.

In some embodiments, these solid state light emitting devices comprise a blue LED that includes a recipient luminophoric medium that has first, second and third phosphors included therein. The first phosphor may down-convert light received from the blue LED to light having a peak wavelength in the green color range. This phosphor may have a sufficiently broad FWHM bandwidth such that its FWHM emission spectra falls into at least part of the cyan color range, In some embodiments, this first phosphor may comprise a LuAG:Ce phosphor (i.e., cerium doped LuAG). LuAG:Ce phosphors may have a peak emission wavelength of between 535 and 545 nanometers, and a FWHM bandwidth of between about 110-115 nanometers. As such, the FWHM bandwidth of LuAG:Ce phosphors may extend throughout the entire cyan color range. The second phosphor may down-convert light received from the blue LED to light having a peak wavelength in the yellow color range. In some embodiments, this second phosphor may comprise a YAG:Ce phosphor. The third phosphor may down-convert light received from the blue LED to light having a peak wavelength in the red color range. In some embodiments, this third phosphor may comprise a (Ca₁₋ₓSrₓ)SiAlN₃:Eu²⁺ phosphor.

In some embodiments, the LuAG:Ce phosphor and the YAG:Ce could be grown together in a single cerium-doped structure that includes lutetium, yttrium, aluminum and oxygen. For example, the LuAG:Ce phosphor and the YAG:Ce could be implemented together as a Lu₁₋ₓYₓAl₅O₁₂:Ce material. Such a material would act as both a first phosphor that emits light like a LuAG:Ce phosphor and a second phosphor that emits light like a YAG:Ce phosphor (which would provide a combined spectra having a peak between the peak wavelength of the LuAG:Ce phosphor and the peak wavelength of the YAG:Ce phosphor). Thus, it will be appreciated that the first and second phosphors may comprise two separate phosphors, two separate phosphors that are mixed together, and/or a composition in which both phosphors are grown together in the same structure.

It will also be appreciated that pursuant to some embodiments of the present invention, the first phosphor may comprise a first aluminum garnet-based phosphor, the second phosphor may comprise a second aluminum garnet-based phosphor, and the third phosphor comprises a nitride- or oxynitride-based phosphor. In some of these embodiments, the first phosphor may emit light in the green color range and the second phosphor may emit light in the yellow color range. In some embodiments, the first phosphor may comprise a LuAG:Ce phosphor or may comprise any other aluminum garnet-based phosphor, and the second phosphor may comprise a YAG:Ce or may comprise any other aluminum garnet-based phosphor. The third phosphor may comprise any suitable nitride- or oxynitride-based phosphor, and is not limited to calcium and strontium based nitride- or oxynitride-based phosphors. It will be understood that the use of first and second aluminum garnet-based phosphors may have certain advantages in particular implementations, as the two aluminum garnet-based phosphors may have good compatability when they are, for example, mixed together in a binder, and as aluminum garnet-based phosphors may exhibit good stability and have other desirable features for use in luminophoric mediums.

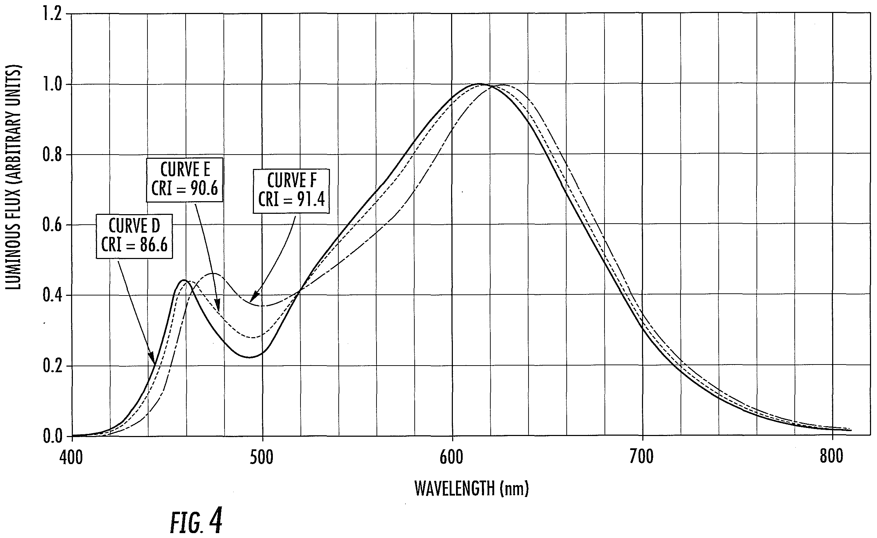

**FIG. 4** is a graph illustrating the intensity of the radiation emitted by three different solid state lighting devices according to embodiments of the present invention as a function of the wavelength. In **FIG. 4****,** all of the solid state devices use a blue LED that has a dominant wavelength of 464 nanometers. In the device used to generate Curve D, the light emitting device is a yellow/red phosphor device that includes a recipient luminophoric medium that has a yellow phosphor (YAG:Ce) and a red phosphor ((Ca₁₋ₓSrₓ)SiAlN₃:Eu²⁺); in the device used to generate Curve E, the LED includes a recipient luminophoric medium that has a green phosphor (LuAG:Ce), a yellow phosphor (YAG:Ce) and a red phosphor ((Ca₁₋ₓSrₓ)SiAlN₃:Eu²⁺) (herein "a green/yellow/red phosphor device"); and in the device used to generate Curve F, the LED includes a recipient luminophoric medium that has a green phosphor (LuAG:Ce) and a red phosphor ((Ca₁₋ₓSrₓ)SiAlN₃:Eu²⁺) (herein "a green/red phosphor device").

As shown in Curve D, the yellow/red phosphor device exhibited a CRI value of 86.6. This device was similar to the device used to generate Curve B of **FIG. 2****,** but exhibited the improved CRI because it had a color point at a different location on the 1931 CIE Chromaticity Diagram of **FIG. 1**. However, the device still has a relatively low percentage of the luminous flux in the cyan color range, and failed to achieve a CRI of greater than 90.

In contrast, the devices of Curves E and F both achieved CRI values of greater than 90. In particular, the green/yellow/red phosphor device that was used to generate Curve E achieved a CRI value of 90.6, and the green/red phosphor device that was used to generate Curve F achieved a CRI value of 91.4. In each case, these devices had an increased percentage of their luminous flux in the cyan color range, which is attributable to the inclusion of the green phosphor that had significant emission in the cyan color range. Curve F also shows that the omission of any yellow phosphor in the device used to generate Curve F shifts the major peak in the spectra (i.e., the peak between 600 and 700 nanometers) to the right (i.e., to higher wavelengths). In the devices used to generate Curves D-F, the ratio of the yellow phosphor to the red phosphor was again varied so that each of the devices would produce a light having a color that was at approximately the same location on the 1931 CIE Chromaticity Diagram illustrated in **FIG. 1****.** This was accomplished by increasing the percentage of red phosphor in the devices that included the green phosphor.

As can be seen from **FIG. 4****,** in the solid state light emitting devices that were used to generate Curves E and F, the inclusion of a green phosphor in the luminophoric medium may help to "fill in" some of the spectral gap in the cyan color range that may be present in light emitted by the conventional yellow/red phosphor devices. As a result, the light emitting devices according to embodiments of the present invention may exhibit high CRI values.

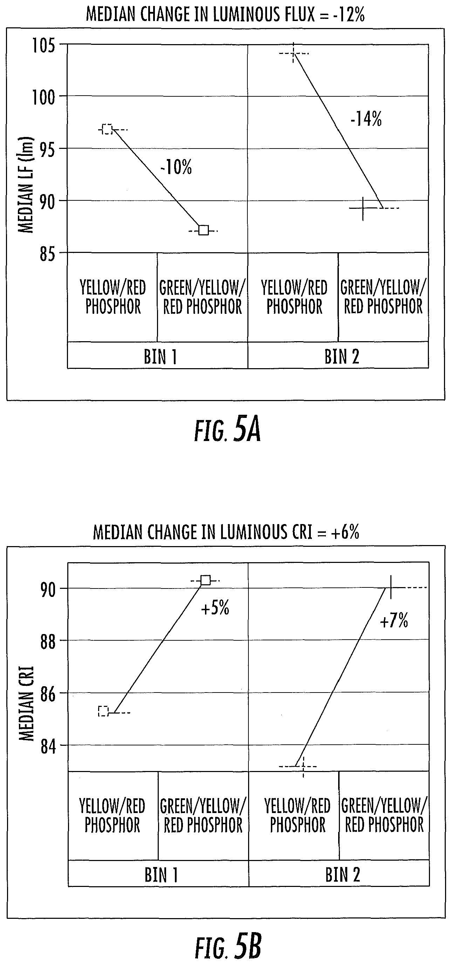

**FIGS. 5A** and **5B** provide additional data showing how the inclusion of a green phosphor in the luminophoric medium to provide a green/yellow/red phosphor device affects the performance of a device as compared to a conventional yellow/red phosphor device. In particular, **FIG. 5A** illustrates the median CRI for a plurality of green/yellow/red phosphor devices according to embodiments of the present invention that fall within two different warm white color bins (a color bin refers to a region on the 1931 CIE Chromaticity Diagram) as compared to the median CRI for a plurality of conventional yellow/red phosphor devices that fall within the same two warm white color bins. As shown in **FIG. 5A****,** in the first color bin, the addition of the green phosphor increased the CRI on average by 5% (from 85 to 90), while in the second color bin the addition of the green phosphor increased the CRI on average by 7% (from 83 to 90). Thus, the addition of the green phosphor resulted in an average increase in CRI of 6%.

**FIG. 5B** illustrates the median luminous flux (in lumens) for the devices used to generate **FIG. 5A****.** As shown in **FIG. 5B****,** the luminous flux of the green/yellow/red phosphor devices that fall within the first warm white color bin is 10% less than the median luminous flux for the yellow/red phosphor devices that fall within the same color bin. With respect to the second color bin, the addition of the green phosphor decreased the luminous flux on average by 14%. Thus, the addition of the green phosphor resulted in an average decrease in luminous flux of about 12%. This decrease in luminous flux is significantly less than the decrease in luminous flux exhibited by conventional green/red phosphor devices, which may be 25-30% or more.

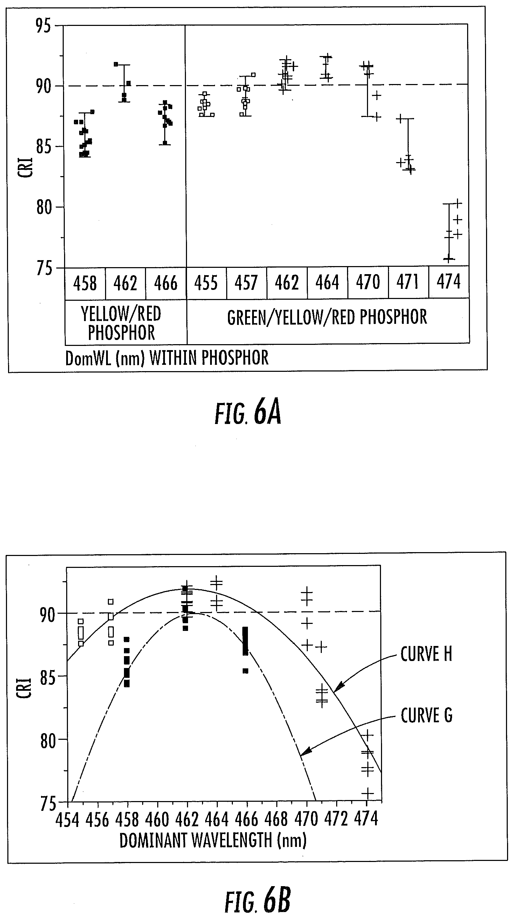

**FIGS. 6A** and **6B** illustrate the effect of the dominant wavelength of the blue LED on both yellow/red phosphor devices and on green/yellow/red phosphor devices according to embodiments of the present invention. In particular, the chart of **FIG. 6A** illustrates the measured CRI for a plurality of yellow/red phosphor devices at each of three dominant wavelengths for the blue LED (458, 462 and 466 nanometers), as well as the measured CRI for a plurality of green/yellow/red phosphor devices at each of seven dominant wavelengths for the blue LED (455, 457, 462, 464, 470, 471 and 474 nanometers). **FIG. 6B** graphically illustrates the data from the chart of **FIG. 6A****,** and provides a curve fit to better illustrate how the CRI values for the yellow/red phosphor devices (Curve G) and for the green/yellow/red phosphor devices (Curve H) vary as a function of the dominant wavelength of the blue LED.

As shown in **FIG. 6B****,** the green/yellow/red phosphor devices generally provide a higher CRI value than do the yellow/red phosphor devices at the same wavelengths. Moreover, the CRI values exhibited by the green/yellow/red phosphor devices fall off more slowly from the peak values than do the CRI values exhibited by the yellow/red phosphor devices. Thus, the solid state lighting devices according to embodiments of the present invention may provide higher CRI values, and may also exhibit acceptable CRI performance over a broader range of dominant wavelengths for the blue LED included in the device.

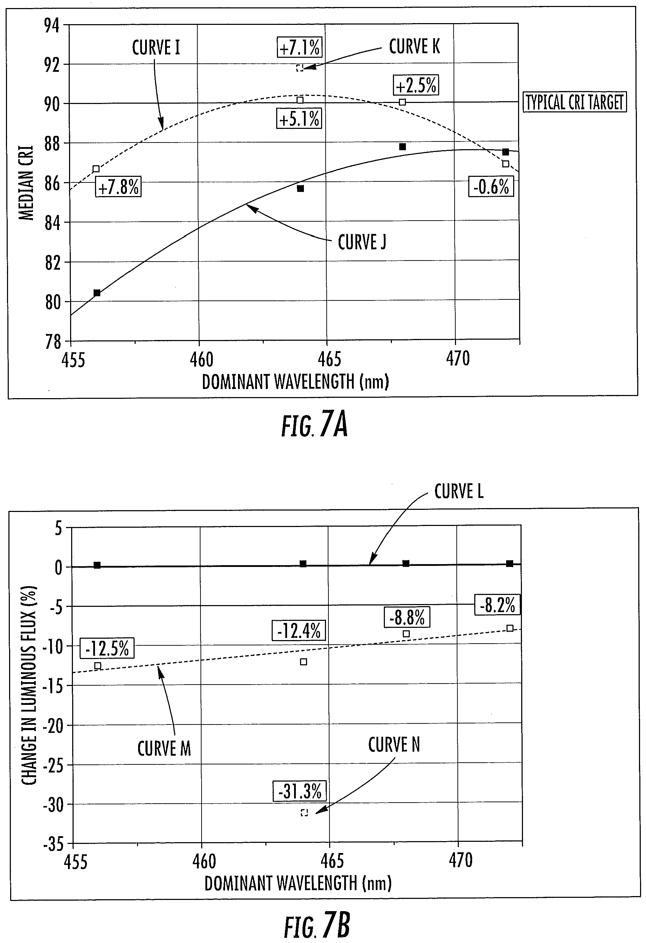

**FIGS. 7A** and **7B** are graphs that further illustrate the differences in CRI and luminous flux for green/yellow/red phosphor devices made according to embodiments of the present invention as compared to conventional yellow/red phosphor devices, as a function of the dominant wavelength of the blue LED included in the devices. **FIG. 7A** illustrates the median CRI values for various devices as a function of the dominant wavelength of the blue LED, while **FIG. 7B** illustrates the luminous flux of the green/yellow/red phosphor devices as a percentage of the luminous flux of yellow/red phosphor devices with blue LEDs having the same dominant wavelengths.

In particular, Curve I in **FIG. 7A** illustrates the CRI of the green/yellow/red phosphor devices, while Curve J illustrates the CRI of the conventional yellow/red phosphor devices. As is apparent from **FIG. 7A****,** the green/yellow/red phosphor devices provide higher CRI values for blue LEDs having a dominant wavelength of less than 471 nanometers. The peak CRI is provided at a wavelength of about 464 nanometers, where the CRI value is 5.1% higher than the CRI value of conventional yellow/red phosphor devices. The improvement in CRI value is higher at dominant wavelengths less than 464 nanometers (i.e., an improvement of 7.8% at 456 nanometers). **FIG. 7A** further includes a single data point labeled Curve K, which illustrates the measured CRI value of a green/red phosphor device that used a blue LED with a dominant wavelength of 464 nanometers. As shown in **FIG. 7A****,** this device exhibits an even higher CRI value of nearly 92, that is 7.1% greater than the CRI value of the yellow/red phosphor device having a blue LED with a dominant wavelength at 464 nanometers.

Turning now to **FIG. 7B****,** Curve L illustrates the luminous flux (in lumens) of several conventional yellow/red phosphor devices. All of these luminous flux values have been normalized to 0. Curve M illustrates the luminous flux (in lumens) of several green/yellow/red phosphor devices, where the luminous flux value is graphed as the percentage change from the luminous flux value of the yellow/red phosphor device having a blue LED at the same dominant wavelength. As shown in **FIG. 7A****,** the green/yellow/red phosphor devices provide decreased luminous flux as compared to the yellow/red phosphor devices. The decrease in luminous flux is greater the lower the dominant wavelength of the blue LED (i.e., the decrease in luminous flux as compared to a comparable yellow/red phosphor device is 8,2% for a blue LED with a dominant wavelength of 472 nanometers, while the decrease in luminous flux as compared to a comparable yellow/red phosphor device is 12.5% for a blue LED with a dominant wavelength of 456 nanometers). **FIG. 7B** further includes a single data point labeled Curve N, which illustrates the normalized luminous flux of a green/red phosphor device that used a blue LED with a dominant wavelength of 464 nanometers. As shown in **FIG. 7B****,** this device exhibits a significant loss in luminous flux of 31.3% as compared to the conventional yellow/red phosphor devices. Thus, while the green/yellow/red phosphor devices according to embodiments of the present invention do exhibit a loss in luminous flux as compared to the conventional yellow/red phosphor devices, this loss is only on the order of 8-12%, whereas comparative loss in luminous flux exhibited by either conventional green/red phosphor devices and the green/red phosphor device of Curve N are on the order of two or more times higher.

As noted above, in some embodiments, the recipient luminophoric medium may include a LuAG:Ce phosphor that emits light having a peak frequency between 535 nanometers and 545 nanometers and a FWHM of 110-115 nanometers, which is primarily in the green color range, aYAG:Ce phosphor that emits light having a peak frequency between 545 nanometers and 565 nanometers and a FWHM of 115-120 nanometers, which is primarily in the yellow color range, and a (Ca₁₋ₓSrₓ)SiAlN₃:Eu²⁺ phosphor that emits light having a peak frequency between 630 nanometers and 650 nanometers and a FWHM of 85-95 nanometers, which is primarily in the red color range. In some embodiments, the ratio of LuAG:Ce phosphor to YAG:Ce phosphor may be between about 3-to-1 and 1-to-3 by weight. In a more specific embodiment, the ratio of LuAG:Ce phosphor to YAG:Ce phosphor may be between about 1.5-to-1 and 1-to-1.5 by weight. In some embodiments, the ratio of the combination of the LuAG:Ce phosphor and the YAG:Ce phosphor to the red phosphor may be between about 1-to-1 and 9-to-1 by weight.

In some embodiments of the present invention, light emitting devices are provided that include a solid state lighting source such as, for example, a blue or ultraviolet LED, and a recipient luminophoric medium for down-converting at least some of the radiation emitted by the solid state lighting source. The luminophoric medium may include a material such as a first phosphor that down-converts the radiation emitted by the solid state lighting source to radiation having a peak wavelength in the green color range that has a FWHM bandwidth that extends into the cyan color range, and one or more additional materials that down-convert the radiation emitted by the solid state lighting source to radiation having a peak wavelength in another color range.

In some embodiments, the first phosphor may down-convert the radiation emitted by the solid state lighting source to a radiation having a peak wavelength between 525 nanometers and 550 nanometers, and has a FWHM emission bandwidth that extends below 500 nanometers. In some embodiments, the one or more additional materials may be second and third phosphors that together down-convert the radiation emitted by the solid state lighting source to radiation having a peak wavelength greater than 580 nanometers. In some embodiments, the second phosphor may down-convert the radiation emitted by the solid state lighting source to radiation having a peak wavelength in the yellow color range, and the third phosphor may down-convert the radiation emitted by the solid state lighting source to radiation having a peak wavelength in the red color range. The first phosphor may be a LuAG:Ce phosphor, the second phosphor may be a YAG:Ce phosphor, and the third phosphor may be a (Ca₁₋ₓSrₓ)SiAlN₃:Eu²⁺ phosphor. Such a light emitting device may emit a warm white light having a correlated color temperature between about 2500K and 4500K, a CRI value of at least 90, and a color point that is within 7 MacAdam ellipses of the black-body locus on a 1931 CIE chromaticity diagram. In some embodiments, the correlated color temperature may be between about 2500K and 3300K.

In further embodiments of the present invention, light emitting devices are provided that include an LED that emits light having a dominant wavelength in the blue color range, and a recipient luminophoric medium that is configured to down-convert at least some of the light emitted by the LED. The recipient luminophoric medium may include at least a first phosphor that down-converts the radiation emitted by the LED to radiation having a peak wavelength in the green color range, a second phosphor that down-converts the radiation emitted by the LED to radiation having a peak wavelength in a second color range having wavelengths above the green color range, and a third phosphor that down-converts the radiation emitted by the LED to radiation having a peak wavelength in a third color range having wavelengths above the green color range. The first phosphor may have a FWHM emission bandwidth that extends into the cyan color range.

In some embodiments, the phosphors included in the recipient luminophoric medium and the LED are configured to together emit warm white light having a correlated color temperature between about 2500K and 4500K (or even between about 2500K and 3300K) and/or having a CRI of at least 90. In some embodiments, the second phosphor down-converts the radiation emitted by the LED to radiation having a peak wavelength in the yellow color range, and the third phosphor down-converts the radiation emitted by the LED to radiation having a peak wavelength in the red color range. The first phosphor may comprise a LuAG:Ce phosphor, the second phosphor comprises a YAG:Ce phosphor, and the third phosphor comprises a (Ca₁₋ₓSrₓ)SiAlN₃:Eu²⁺ phosphor.

In still further embodiments, light emitting devices are provided that include a LED that emits light having a dominant wavelength in the blue color range and a recipient luminophoric medium that is configured to down-convert at least some of the light emitted by the LED. The recipient luminophoric medium includes a first material that down-converts the radiation emitted by the LED to radiation having a peak wavelength in the green color range and a second material that down-converts the radiation emitted by the LED to radiation having a peak wavelength in a second color range having wavelengths above the green color range. The spectra emitted by the light emitting device has two distinct peaks in the visible spectrum, including a first peak in the blue color range, a second peak at wavelengths longer than the wavelengths associated with the green color range.

In some embodiments, the first material may be a first phosphor such as, for example, a LuAG:Ce phosphor, that down-converts the radiation emitted by the LED to radiation having a peak wavelength in the green color range and that as a FWHM emission bandwidth that extends into the cyan color range, and the second material may be a second phosphor such as, for example, aYAG:Ce phosphor, that down-converts the radiation emitted by the LED to a radiation having a peak wavelength in the yellow color range and a third phosphor such as, for example, (Ca₁₋ₓSrₓ)SiAlN₃:Eu²⁺ phosphor, which down-converts the radiation emitted by the LED to a radiation having a peak wavelength in the red color range. The LED may emit a warm white light having a correlated color temperature between about 2500K and 4500K (or even between about 2500K and 3300K) and a CRI value of at least 90.

In some embodiments, the LED (or other solid state light emitting device) may emit light having a dominant frequency between about 430 nanometers to 470 nanometers. The first phosphor may emit light having a peak frequency between about 525 nanometers to 545 nanometers. The second phosphor may emit light having a peak frequency between about 545 nanometers to 585 nanometers. The third phosphor may emit light having a peak frequency between about 600 nanometers to 650 nanometers.

The phosphor particles for the green, yellow and red phosphors may range in diameter (the term diameter is used loosely, as the particles will not necessarily have a spherical shape) may range from about 1 micron to about 30 microns, with about half of the particles being from between about 4 microns to about 20 microns in diameter. In some embodiments, at least half of the particles of the green, yellow and red phosphors may have a size (diameter) in the range between 2 microns and 20 microns.

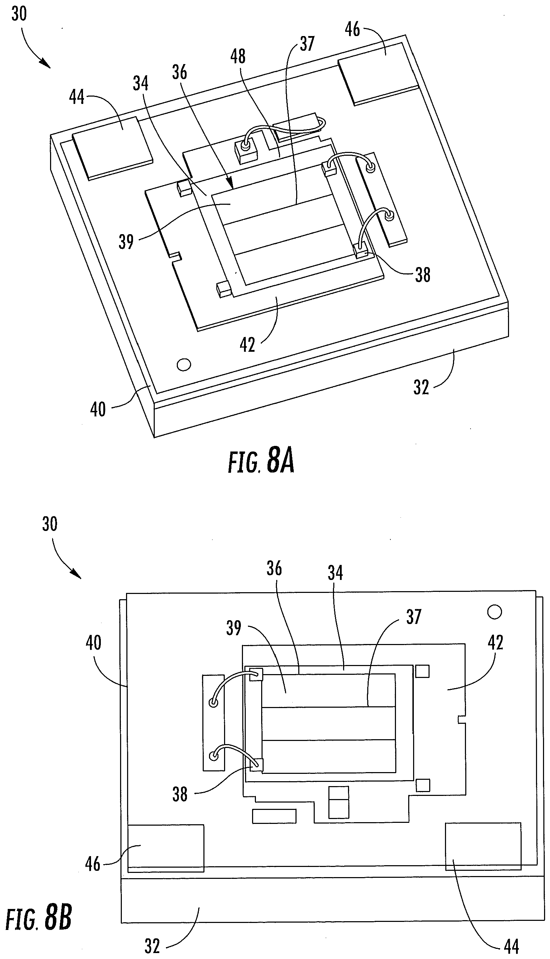

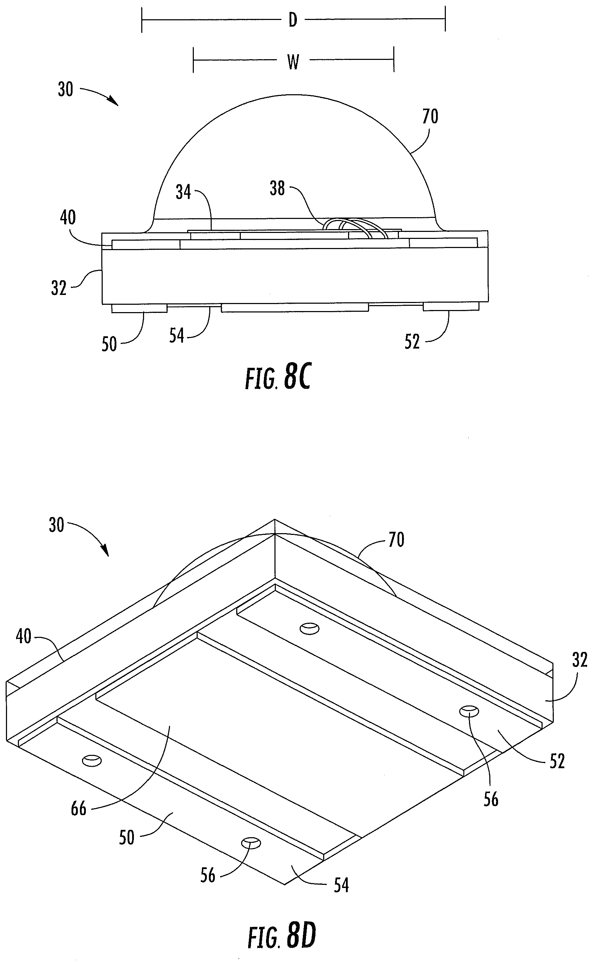

A solid state light emitting device **30** will now be descried that includes a luminophoric medium according to embodiments of the present invention with reference to **FIGS. 8A-8D****.** The solid state light emitting device **30** comprises a packaged LED. In particular, **FIG. 8A** is a perspective view of the solid state light emitting device **30** without a lens thereon. **FIG. 8B** is a perspective view of the device **30** viewed from the opposite side. **FIG. 8C** is a side view of the device **30** with a lens covering the LED chip. **FIG. 8D** is a bottom perspective view of the device **30.**

As shown in **FIG. 8A****,** the solid state light emitting device **30** includes a substrate/submount ("submount") **32** on which a single LED chip or "die" **34** is mounted. The submount **32** can be formed of many different materials such as, for example, aluminum oxide, aluminum nitride, organic insulators, a printed circuit board (PCB), sapphire or silicon. The LED **34** can have many different semiconductor layers arranged in different ways. LED structures and their fabrication and operation are generally known in the art and hence are only briefly discussed herein. The layers of the LED **34** can be fabricated using known processes such as, for example, metal organic chemical vapor deposition (MOCVD). The layers of the LED **34** may include at least one active layer/region sandwiched between first and second oppositely doped epitaxial layers all of which are formed successively on a growth substrate. Typically, many LEDs are grown on a growth substrate such as, for example, a sapphire, silicon carbide, aluminum nitride (AlN), or gallium nitride (GaN) substrate to provide a grown semiconductor wafer, and this wafer may then be singulated into individual LED dies, which are mounted in a package to provide individual packaged LEDs. The growth substrate can remain as part of the final singulated LED or, alternatively, the growth substrate can be fully or partially removed. In embodiments where the growth substrate remains, it can be shaped and/or textured to enhance light extraction.

It is also understood that additional layers and elements can also be included in the LED **34,** including but not limited to buffer, nucleation, contact and current spreading layers as well as light extraction layers and elements. It is also understood that the oppositely doped layers can comprise multiple layers and sub-layers, as well as super lattice structures and interlayers. The active region can comprise, for example, a single quantum well (SQW), multiple quantum well (MQW), double heterostructure and/or super lattice structure. The active region and doped layers may be fabricated from different material systems, including, for example, Group-III nitride based material systems such as GaN, aluminum gallium nitride (AlGaN), indium gallium nitride (InGaN) and/or aluminum indium gallium nitride (AlInGaN). In some embodiments, the doped layers are GaN and/or AlGaN layers, and the active region is an InGaN layer.

The LED **34** may be an ultraviolet, violet or blue LED that emits radiation with a dominant wavelength in a range of about 380 nm to about 475 nm.

The LED **34** may include a conductive current spreading structure **36** on its top surface, as well as one or more contacts **38** that are accessible at its top surface for wire bonding. The spreading structure **36** and contacts **38** can both be made of a conductive material such as Au, Cu, Ni, In, Al, Ag or combinations thereof, conducting oxides and transparent conducting oxides. The current spreading structure **36** may comprise conductive fingers **37** that are arranged in a pattern on the LED **34** with the fingers spaced to enhance current spreading from the contacts **38** into the top surface of the LED **34.** In operation, an electrical signal is applied to the contacts **38** through a wire bond as described below, and the electrical signal spreads through the fingers **37** of the current spreading structure **36** into the LED **34.** Current spreading structures are often used in LEDs where the top surface is p-type, but can also be used for n-type materials.

The LED **34** may be coated with a luminophoric medium **39** according to embodiments of the present invention. As discussed above, this recipient luminophoric medium **39** may include multiple phosphors (or other luminescent materials) that absorb at least some of the LED light and emit a different wavelength of light such that the LED emits a combination of light from the LED and the phosphors. In some embodiments, the recipient luminophoric medium **39** includes particles of a green phosphor, particles of a yellow phosphor and particles of a red phosphor mixed therein (together and/or in separate layers). It will be understood that the recipient luminophoric medium **39** may comprise any of the recipient luminophoric mediums discussed in the present disclosure.

The recipient luminophoric medium **39** may be coated on the LED **34** using many different methods, with suitable methods being described in U.S. Patent Applications Serial Nos. 11/656,759 and 11/899,790, both entitled *Wafer Level Phosphor Coating Method and Devices Fabricated Utilizing Method.* Alternatively the recipient luminophoric medium **39** may be coated on the LED **34** using other methods such an electrophoretic deposition (EPD), with a suitable EPD method described in U.S. Patent Application No. 11/473,089 entitled *Close Loop Electrophoretic Deposition of Semiconductor Devices.* Several exemplary methods of coating or otherwise applying the recipient luminophoric medium **39** onto the LED **34** are described below.

An optical element or lens **70** (see **FIGS. 8C-8D**) is formed on the top surface **40** of the submount **32,** over the LED **34,** to provide both environmental and/or mechanical protection. The lens **70** can be molded using different molding techniques such as those described in U.S. Patent Application Serial No. 11/982,275 entitled *Light Emitting Diode Package and Method for Fabricating Same.* The lens **70** can be many different shapes such as, for example, hemispheric. Many different materials can be used for the lens **70** such as silicones, plastics, epoxies or glass. The lens **70** can also be textured to improve light extraction. In some embodiments, the lens **70** may comprise the recipient luminophoric medium **39** and/or may be used to hold a luminophoric medium **39** in place over the LED **34** instead of and/or in addition to coating a luminophoric medium **39** directly onto the LED chip **34.**

The solid state light emitting device **30** may comprise an LED package having different sizes or footprints. In some embodiments, the surface area of the LED chip **34** may cover more than 10% or even 15% of the surface area of the submount **32.** In some embodiments, the ratio of the width W of the LED chip **34** to the diameter D (or width D, for square lens) of the lens **70** may be greater than 0.5. For example, in some embodiments, the solid state light emitting device **30** may comprise an LED package having a submount **32** that is approximately 3.45 mm square and a hemispherical lens having a maximum diameter of approximately 2.55 mm. The LED package may be arranged to hold an LED chip that is approximately 1.4 mm square. In this embodiment, the surface area of the LED chip **34** covers more than 16% of the surface area of the submount **32.**

The top surface **40** of the submount **32** may have patterned conductive features that can include a die attach pad **42** with an integral first contact pad **44.** A second contact pad **46** is also included on the top surface **40** of the submount **32** with the LED **34** mounted approximately at the center of the attach pad **42.** The attach pad **42** and first and second contact pads **44, 46** may comprise metals or other conductive materials such as, for example, copper. The copper pads **42, 44, 46** may be plated onto a copper seed layer that is, in turn, formed on a titanium adhesion layer. The pads **42, 44, 46** may be patterned using standard lithographic processes. These patterned conductive features provide conductive paths for electrical connection to the LED **34** using known contacting methods. The LED **34** can be mounted to the attach pad **42** using known methods and materials.

A gap **48** (see **FIG. 8A**) is included between the second contact pad **46** and the attach pad **42** down to the surface of the submount **32.** An electrical signal is applied to the LED **34** through the second pad **46** and the first pad **44,** with the electrical signal on the first pad **44** passing directly to the LED **34** through the attach pad **42** and the signal from the second pad **46** passing into the LED **34** through wire bonds. The gap **48** provides electrical isolation between the second pad **46** and attach pad **42** to prevent shorting of the signal applied to the LED **34.**

Referring to **FIGS. 8C** and **8D****,** an electrical signal can be applied to the package **30** by providing external electrical contact to the first and second contact pads **44, 46** via first and second surface mount pads **50, 52** that are formed on the back surface **54** of the submount **32** to be at least partially in alignment with the first and second contact pads **44, 46,** respectfully. Electrically conductive vias **56** are formed through the submount **32** between the first mounting pad **50** and the first contact pad **44,** such that a signal that is applied to the first mounting pad **50** is conducted to first contact pad **44.** Similarly, conductive vias **56** are formed between the second mounting pad **52** and second contact pad **46** to conduct an electrical signal between the two. The first and second mounting pads **50, 52** allow for surface mounting of the LED package **30** with the electrical signal to be applied to the LED **34** applied across the first and second mounting pads **50, 52.**

The pads **42, 44, 46** provide extending thermally conductive paths to conduct heat away from the LED **34.** The attach pad **42** covers more of the surface of the submount **32** than the LED **34,** with the attach pad extending from the edges of the LED **34** toward the edges of the submount **32.** The contact pads **44, 46** also cover the surface of the submount **32** between the vias **56** and the edges of the submount **32.** By extending the pads **42, 44, 46,** the heat spreading from the LED **34** may be improved, which may improve the operating life of the LED and/or allow for higher operating power.

The LED package **30** further comprises a metalized area **66** on the back surface **54** of the submount **32,** between the first and second mounting pads **50, 52.** The metalized area **66** may be made of a heat conductive material and may be in at least partial vertical alignment with the LED **34.** In some embodiments, the metalized area **66** is not in electrical contact with the elements on top surface of the submount **32** or the first and second mounting pads **50, 52** on the back surface of the submount **32.** Although heat from the LED is spread over the top surface **40** of the submount **32** by the attach pad **42** and the pads **44, 46,** more heat will pass into the submount **32** directly below and around the LED **34.** The metalized area **66** can assist with this dissipation by allowing this heat to spread into the metalized area **66** where it can dissipate more readily. The heat can also conduct from the top surface **40** of the submount **32,** through the vias **56,** where the heat can spread into the first and second mounting pads **50, 52** where it can also dissipate.

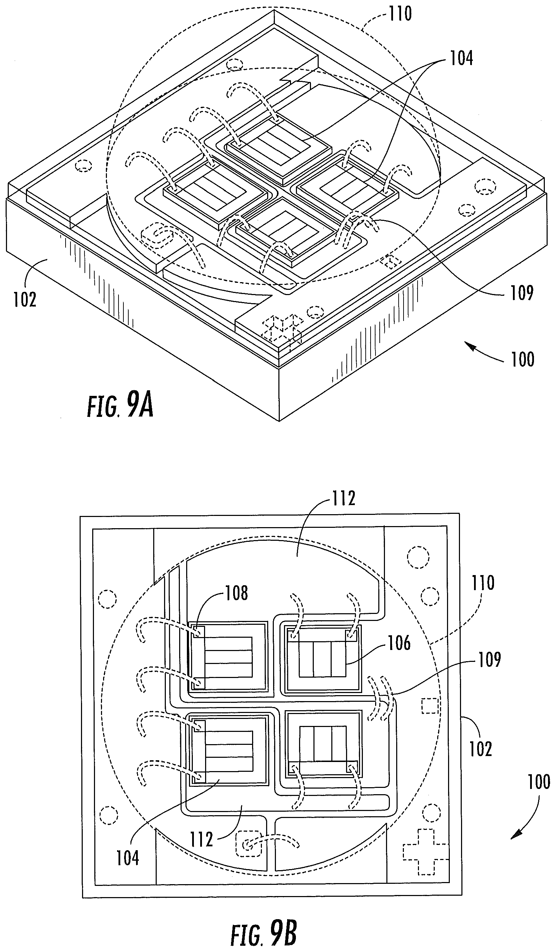

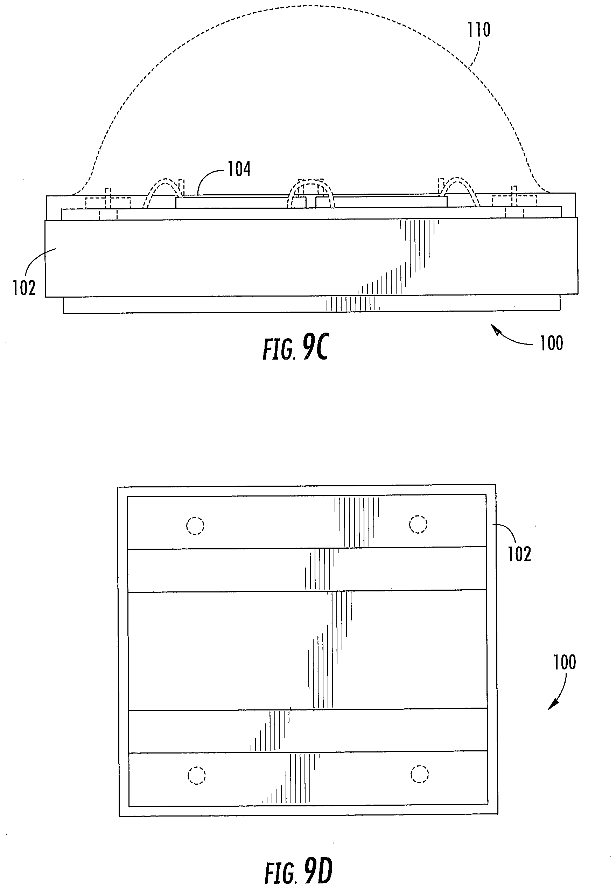

**FIGS. 9A-9D** illustrate a packaged light emitting device **100** that includes multiple LED chips and one or more recipient luminophoric mediums according to embodiments of the present invention. **FIG. 9A** is a perspective view of the packaged light emitting device **100.** **FIG. 9B** is a plan view of the packaged light emitting device **100.** **FIG. 9C** is a side view of the packaged light emitting device **100.** **FIG. 9D** is a bottom view of the packaged light emitting device **100.** While some elements in **FIGS. 9A-9C** are shown using dotted lines as these are elements that may be omitted or positioned differently in various other embodiments, it will be appreciated that these elements could alternatively be shown with solid lines. It will be appreciated that various of the elements drawn with solid lines in **FIGS. 9A-9C** could also be omitted or repositioned,

As shown in **FIG. 9A****,** the packaged light emitting device **100** includes four LED die **104,** which are mounted on a common substrate or submount **102.** The submount **102** and the LEDs **104** can be, for example, any of the submounts and LEDs that are discussed above with respect to **FIGS. 8A-8D****.** In some embodiments, the LEDs **104** may, for example, each be an ultraviolet, violet or blue LED that emits radiation with a dominant wavelength in a range of about 380 nm to about 475 nm. In other embodiments, at least one the LEDs **104** may be an ultraviolet, violet or blue LED that emits radiation with a dominant wavelength in a range of about 380 nm to about 475 nm, while at least one other of the LEDs **104** may be an LED that emits radiation with a dominant wavelength above 550 nm. For example, in some embodiments, the LEDs **104** may include one or more LEDs that emit radiation with a dominant wavelength in the blue color range and at least one or more LEDs **104** that emit radiation with a dominant wavelength in the red color range.

In some embodiments, each of the LEDs **104** may be coated with a recipient luminophoric medium according to embodiments of the present invention (not shown). As discussed above, this recipient luminophoric medium may include multiple phosphors (or other luminescent materials) that absorb at least some of the LED light and emit a different wavelength of light such that the LED emits a combination of light from the LED and the phosphors. In some embodiments, the recipient luminophoric medium includes particles of a green phosphor, particles of a yellow phosphor and particles of a red phosphor mixed therein (together and/or in separate layers). It will be understood that the recipient luminophoric medium may comprise any of the recipient luminophoric mediums discussed in the present disclosure.

The recipient luminophoric medium may be applied to the LEDs **104** in any suitable manner including, for example, by coating the wafer(s) from which the LEDs 104 grown using the coating methods described in the above-referenced U.S. Patent Application Serial Nos. 11/656,759, 11/899,790, or 11/473,089, or by any of the exemplary methods of coating or otherwise applying a recipient luminophoric medium onto an LED at either the wafer level or the die level that are described below. As described below, the recipient luminophoric medium may alternatively be deposited onto and/or built into a lens **110** of packaged light emitting device **100,** or may be provided between the lens **110** and the LEDs **104.** Exemplary techniques for providing the recipient luminophoric medium on or next to a lens such as lens **110** will be discussed below.

Each LED **104** in the packaged light emitting device **100** may include a conductive current spreading structure **106** on its top surface such as the current spreading structures **36** discussed above with respect to light emitting device **30,** as well as one or more contacts **108** that are accessible at its top surface for wire bonding. An optical element or lens **110** is formed on a the top surface of the submount **102,** over the four LEDs **104,** to provide environmental and/or mechanical protection. The lens **110** may be any suitable lens, including any of the lenses **70** discussed above with respect to the light emitting device **30** of **FIGS. 8A-8D****.** In some embodiments, a recipient luminophoric medium may be deposited on and/or included within the lens **110,** or the lens **110** may be used to hold such a recipient luminophoric medium in place over the LEDs **104** instead of and/or in addition to providing recipient luminophoric mediums directly on each of the LED chips **104.**

While **FIGS. 9A-9C** illustrate two wire bonds being attached to the top side of each LED **104,** it will be appreciated that more or less wire bonds may be used. In the depicted embodiment, two wire bonds are attached to each LED **104,** which may comprise two contacts to an n-type layer of the LED, two contacts to a p-type layer of the LED, or one contact to an n-type layer and one contact to a p-type layer of the LED. Additional contacts may be provided on the bottom side of each LED **104.** For example, if the two wire bonds that attach to a particular one of the LEDs **104** in the light emitting device **100** of **FIGS. 9A-****9C** comprise wire bonds that attach to contact pads on an n-type layer of the LED **104,** then one or more additional contacts (which may be, for example, contact pads) may be provided on the bottom side of LED **104** to provide an external contact to the p-side layers of the light emitting device **104**,

It will also be appreciated that additional wire bonds or other contacting structures may be provided that may be used to electrically connect the LEDs **104** in series, in parallel, or in a combination thereof. Two such wirebonds **109** are shown in **FIGS. 9A-9B****.**

The top surface of the submount **102** may have patterned conductive features that can include die attach pads **112** which the LEDs **104** may be mounted on. Electrical contact may be made to each of the LEDs **104** using known wire bonding and contact methods such as, for example, those discussed above with respect to the light emitting device **30** of FIGS. **8A-8B** and or though electrical connections to the die attach pads **112** The patterned conductive features that include the die attach pads **112** may have reflective upper surfaces. The recipient luminophoric mediums according to embodiments of the present invention may be coated onto or otherwise deposited on these patterned conductive features in some embodiments, and may thereby act to further down-convert light emitted by the LEDs **104** that impinges on these reflective surfaces.

The bottom side of the packaged light emitting device **100** (**FIG. 9D**) may be substantially identical to the bottom side of the packaged light emitting device **30** (albeit, likely larger), and hence further description thereof will be omitted herein. An electrical signal can be applied to the packaged light emitting device **100** by providing external electrical contact to first and second surface mount pads (not shown) that are formed on the back surface of the submount **102.** This electrical signal may be applied to each of the LEDs **104** in the same manner, described above, that an electrical signal is provided to the LED **34** of **FIGS. 8A-8D****.**

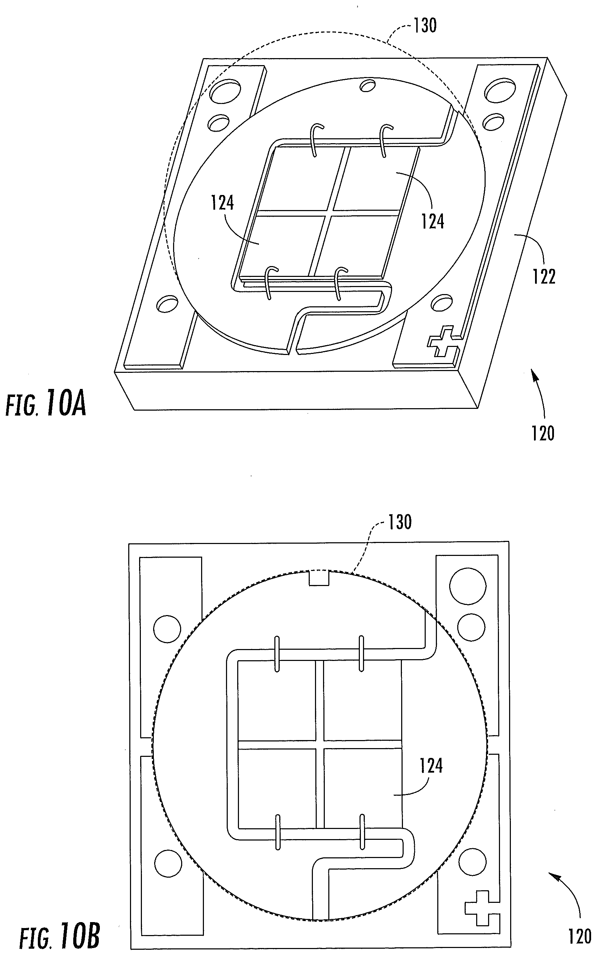

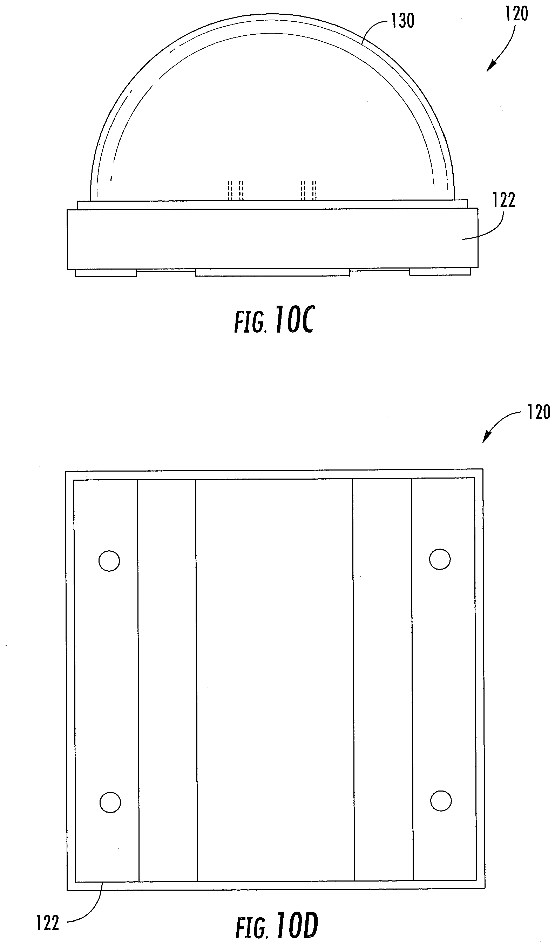

**FIGS. 10A-10D** illustrate another packaged light emitting device **120** that includes multiple LED chips and one or more recipient luminophoric mediums according to embodiments of the present invention. In particular, **FIG. 10A** is a perspective view of the packaged light emitting device **120.** **FIG. 10B** is a plan view of the packaged light emitting device **120.** **FIGS. 10C** and **10D** are side and bottom views of the packaged light emitting device **120.**

As is apparent from the figures, the packaged light emitting device **120** of **FIGS. 10A-10D** is very similar to the packaged light emitting device **100** of **FIGS. 9A-9D****.** The primary difference between the two devices **100, 120** is that the device **100** uses LEDs **104** that have two top-side contacts and hence have two top-side wire bonds **109** between each LED chip **104** and the submount **102,** while the device **120** uses LEDs **124** that have a single top-side contact and hence have a single top-side wire bond between each LED chip **124** and the submount **122.** Each of the LEDs **124** in packaged light emitting device **120** may operate in conjunction with a recipient luminophoric medium according to embodiments of the present invention (not shown), specifically including recipient luminophoric medium that have particles of a green phosphor, particles of a yellow phosphor and particles of a red phosphor mixed therein (together and/or in separate layers). The recipient luminophoric medium may be deposited on a top surface of the LEDs **124,** deposited on and/or included within a lens **130** of the packaged light emitting device **120,** and/or provided between the lens **130** and the LEDs **124.**

The recipient luminophoric medium may be applied to the LEDs **124** or the lens **130,** or mounted therebetween, in any suitable manner including, for example, each of the methods discussed above with respect to packaged light emitting device **100** and/or the various additional methods discussed below.

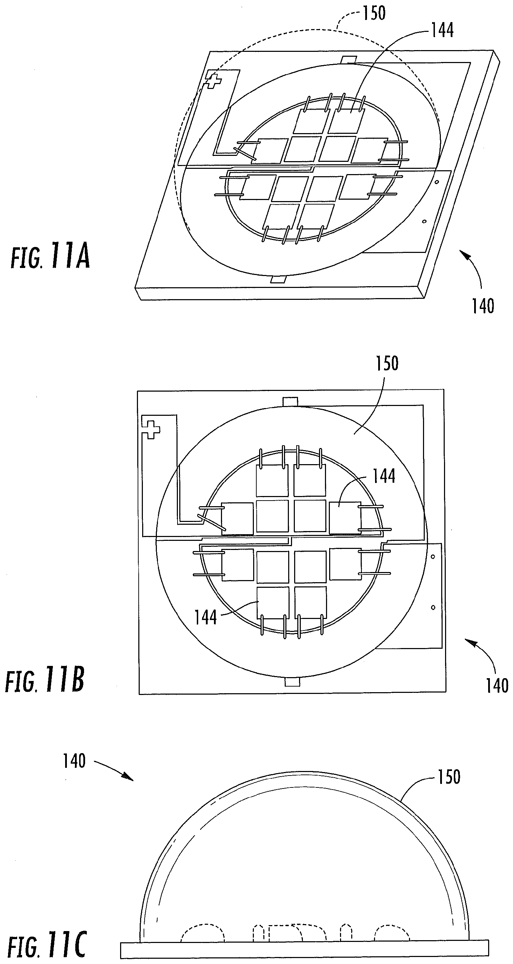

**FIGS. 11A-11C** illustrate another packaged light emitting device **140** that includes multiple LED chips and one or more recipient luminophoric mediums according to embodiments of the present invention. In particular, **FIG. 11A** is a perspective view of the packaged light emitting device **140.** **FIG. 11B** is a plan view of the packaged light emitting device **140.** **FIG. 11C** is a side view of the packaged light emitting device **140.**

The packaged light emitting device **140** of **FIGS. 11A-11D** is similar to the packaged light emitting device **100** of **FIGS. 9A-9D****,** with the primary difference being that the packaged light emitting device includes a total of twelve LEDs **144** as opposed to the four LEDs **104** included in packaged light emitting device **100.** Each of the LEDs **144** in packaged light emitting device **140** may operate in conjunction with a recipient luminophoric medium according to embodiments of the present invention, specifically including recipient luminophoric mediums that have particles of a green phosphor, particles of a yellow phosphor and particles of a red phosphor mixed therein (together and/or in separate layers). The recipient luminophoric medium(s) may be deposited on a top surface of the LEDs **144,** deposited on and/or included within a lens **150** of the packaged light emitting device **140,** and/or provided between the lens **150** and the LEDs **144.** The recipient luminophoric medium may be applied to the LEDs **144** or the lens **150,** or mounted therebetween using, for example, any of the methods of depositing a recipient luminophoric medium discussed herein. As the packaged light emitting device **140** may be essentially identical to the packaged light emitting device **100** with the exception of having a different number of LEDs and appropriate wire bonds and contacts therefore, further discussion of the packaged light emitting device **140** will be omitted.

It will be appreciated that while **FIGS. 8A-11C** illustrate several exemplary packaged light emitting devices that may include recipient luminophoric mediums according to embodiments of the present invention, these recipient luminophoric mediums may generally be used with any suitable packaged light emitting devices. By way of further example, additional exemplary packaged LEDs are disclosed in U.S. Provisional Patent Application No. 61/173,550, filed April 28, 2009. The recipient luminophoric mediums according to embodiments of the present invention may be used with respect to any of the packaged LEDs disclosed in this provisional patent application.

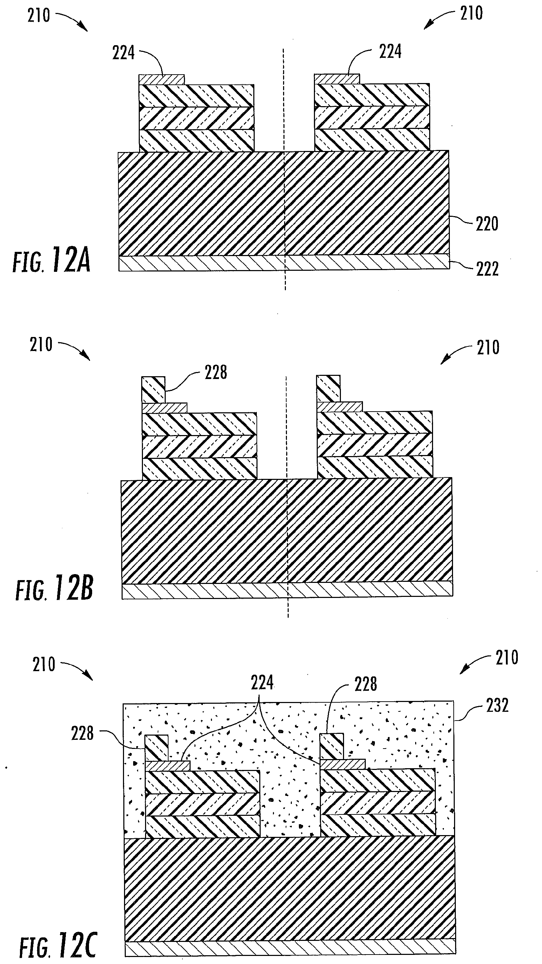

As noted above, in some embodiments, the recipient luminophoric mediums according to embodiments of the present invention may be directly coated onto a surface of a semiconductor wafer before the wafer is singulated into, for example, individual LED chips. One such process for applying the recipient luminophoric medium will now be discussed with respect to **FIGS. 12A-12E****.** In the example of **FIGS. 12A-12E****,** the recipient luminophoric medium is coated onto a plurality of LED chips **210.** In this embodiment, each LED chip **210** is a vertically-structured device that has a top contact **224** and a bottom contact **222.**

Referring to **FIG. 12A****,** a plurality of LED chips **210** (only two are shown) are shown at a wafer level of their fabrication process (i.e., before the wafer has been separated/singulated into individual LED chips). Each of the LED chips **210** comprises a semiconductor LED that is formed on a substrate **220.** Each of the LED chips **210** has first and second contacts **222, 224.** The first contact **222** is on the bottom of the substrate **220** and the second contact **224** is on the top of the LED chip **210.** In this particular embodiment, the top contact **224** is a p-type contact and the contact **222** on the bottom of the substrate **220** is an n-type contact. However, it will be appreciated that in other embodiments, the contacts **222, 224** may be arranged differently. For example, in some embodiments, both the contact **222** and the contact **224** may be formed on an upper surface of the LED chip **210.**

As shown in **FIG. 12B****,** a conductive contact pedestal **228** is formed on the top contact **224** that is utilized to make electrical contact to the p-type contact **224** after the LED chips **210** are coated with a luminophoric medium. The pedestal **228** can be formed of many different electrically conductive materials and can be formed using many different known physical or chemical deposition processes such as electroplating, mask deposition (e-beam, sputtering), electroless plating, or stud bumping. The height of the pedestal **228** can vary depending on the desired thickness of the luminophoric medium and should be high enough to match or extend above the top surface of the luminophoric medium coating that is deposited in a later step.

As shown in **FIG. 12C****,** the wafer is blanketed by a recipient luminophoric medium coating **232** that covers each of the LED chips **210,** the contacts **222,** and the pedestals **228.** The luminophoric medium coating **232** may comprise a binder and a plurality of phosphors. The phosphors may comprise, for example, the phosphor combinations discussed above according to embodiments of the present invention. The material used for the binder may be a material that is robust after curing and substantially transparent in the visible wavelength spectrum such as, for example, a silicone, epoxy, glass, inorganic glass, spin-on glass, dielectrics, BCB, polymides, polymers and the like. The luminophoric medium coating **232** can be applied using different processes such as spin coating, dispensing, electrophoretic deposition, electrostatic deposition, printing, jet printing or screen printing. Yet another suitable coating technique is disclosed in U.S. Patent Application Serial No. 12/717,048, filed March 3, 2010. The luminophoric medium coating **232** can then be cured using an appropriate curing method (e.g., heat, ultraviolet (UV), infrared (IR) or air curing).

Different factors determine the amount of LED light that will be absorbed by the luminophoric medium coating **232** in the final LED chips **210,** including but not limited to the size of the phosphor particles, the percentage of phosphor loading, the type of binder material, the efficiency of the match between the type of phosphor and wavelength of emitted light, and the thickness of the luminophoric medium coating **232.** Many different phosphors can be used in the recipient luminophoric medium coating **232** according to the present invention. As discussed above, in some embodiments, the recipient luminophoric medium coating **232** may include a green phosphor, a yellow phosphor and a red phosphor. The green phosphor may have a FWHM bandwidth that may extend into, or even all the way across, the cyan color range. The green phosphor may comprise, for example, LuAG:Ce. Other phosphors that emit at or near the green color range include, but are not limited to, Sr₆P₅BO₂₀:Eu; MSi₂O₂N₂:Eu²⁺; and Zinc Sulfide:Ag with (Zn,Cd)S:Cu:Al, or other combinations. The yellow phosphor may comprise, for example, YAG:Ce. Other suitable yellow phosphors include Tb₃₋ₓREₓO₁₂:Ce(TAG) where RE=Y, Gd, La, Lu; and Sr_{2-x-y}BaₓCa_{y}SiO₄:Eu. The red phosphor may comprise, for example, (Ca₁₋ₓSrₓ)SiAlN₃:Eu²⁺. Other red or orange phosphors that could be used in certain embodiments include Lu₂O₃:Eu³⁺; (Sr₂₋ₓLaₓ)(Ce₁₋ₓEuₓ)O₄; Sr₂Ce₁₋ₓEuₓO₄; Sr₂₋ₓEuₓCeO₄; SrTiO₃:Pr³⁺,Ga³⁺; CaAlSiN₃:Eu²⁺; and/or Sr₂Si₅N₈:Eu²⁺. It will be understood that many other phosphors can used alone or in combination to achieve the desired combined spectral output.

Different sized phosphor particles can be used including, but not limited to, 10-100 nanometer (nm)-sized particles to 20-30 µm sized particles, or larger. Smaller particle sizes typically scatter and mix colors better than larger sized particles to provide a more uniform light. Larger particles are typically more efficient at converting light compared to smaller particles, but emit a less uniform light. In some embodiments, the phosphor particles for the green, yellow and red phosphors may range in size from about 1 micron to about 30 microns, with about half of the particles being from between about 4 microns to about 20 microns. In some embodiments, at least half of the particles of the green, yellow and red phosphors may have a size (diameter) in the range between 2 microns and 20 microns. Different sized phosphors can be included in the recipient luminophoric medium coating **232** as desired before it is applied such that the end coating **232** can have the desired combination of smaller sizes to effectively scatter and mix the light, and larger sizes to efficiently convert the light.

The coating **232** can also have different concentrations or loading of phosphor materials in the binder, with a typical concentration being in range of 30-70% by weight. In one embodiment, the phosphor concentration is approximately 65% by weight, and is may be generally uniformly dispersed throughout the binder. In other embodiments the coating **232** can comprise multiple layers of different concentrations or types of phosphors, and the multiple layers can comprise different binder materials. One or more of the layers can be provided without phosphors. For example, a first coat of clear silicone can be deposited followed by phosphor loaded layers. As another example, the coating may comprise, for example, a three layer coating that includes a first layer having a first phosphor with a peak wavelength in the green color range that is coated directly on the LED chips **210,** a second layer having a second phosphor with a peak wavelength in the yellow color range that is coated directly on the first layer, and a third layer having a third phosphor with a peak wavelength in the red color range that is coated directly on the second phosphor. Numerous other layer structures are possible, including multi-layers that include multiple phosphors in the same layer. Intervening layers or elements could also be provided between layers and/or between the coating and the underlying LED chips **210.**

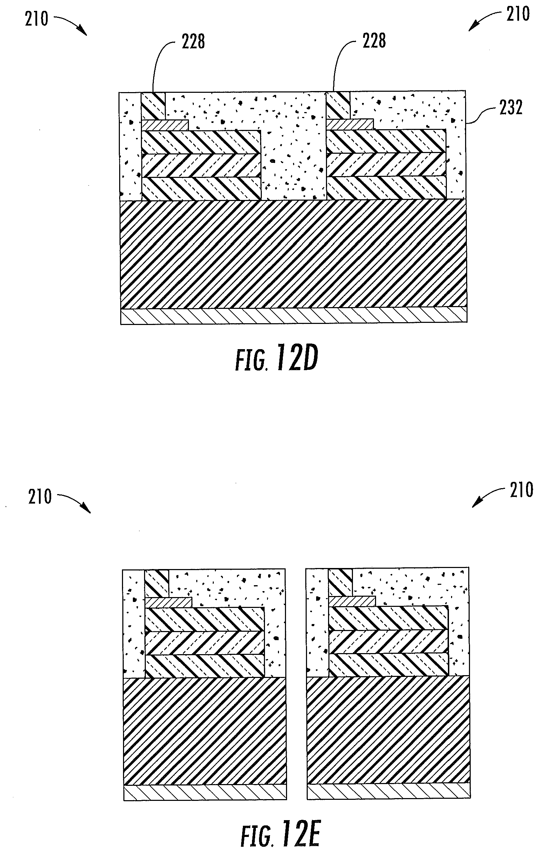

After the initial coating of the LED chips **210** with the recipient luminophoric medium coating **232,** further processing is needed to expose the pedestals **228.** Referring now the **FIG. 12D****,** the coating **232** is thinned or planarized to expose the pedestals **228** through the top surface of the coating **232.** The thinning process exposes the pedestals **228,** planarizes the coating **232** and allows for control of the final thickness of the coating **232.** Based on the operating characteristics of the LEDs **210** across the wafer and the properties of the phosphor (or fluorescent) material selected, the end thickness of the coating **232** can be calculated to reach a desired color point/range and still expose the pedestals **228.** The thickness of the coating **232** can be uniform or non-uniform across the wafer.

As shown in **FIG. 12E****,** after the coating **232** is applied, the individual LED chips **210** can be singulated from the wafer using known methods such as dicing, scribe and breaking, or etching. The singulating process separates each of the LED chips **210** with each having substantially the same thickness of coating **232,** and as a result, substantially the same amount of phosphor and thus substantially the same emission characteristics. Following singulation of the LED chips **210,** a layer of coating **232** remains on the side surfaces of the LEDs **210** and light emitting from the side surfaces of the LEDs **210** also passes through the coating **232** and its phosphor particles. This results in conversion of at least some of the side emitting light, which can provide LED chips **210** having more consistent light emitting characteristics at different viewing angles.

Following singulation, the LED chips **210** can be mounted in a package, or to a submount or printed circuit board (PCB) without the need for further processing to add phosphor. In one embodiment the package/submount/PCB can have conventional package leads with the pedestals **228** electrically connected to the leads. A conventional encapsulation can then surround the LED chip **210** and electrical connections.

Pursuant to further embodiments of the present invention, recipient luminophoric mediums may be applied to a light emitting device while the light emitting device is exposed to a curing agent. The curing agent may be, for example, heat, radiation, a material that is present on or in the light emitting device, or other agents that speed up the curing of the recipient luminophoric medium.

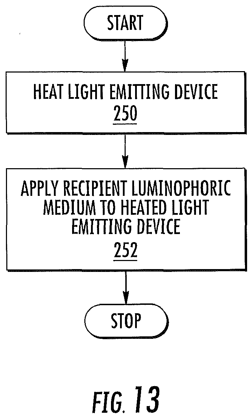

Reference is now made to **FIG. 13****,** which is a flow diagram illustrating operations for applying a recipient luminophoric medium onto a light emitting device where heat is applied as a curing agent during the application of the recipient luminophoric medium. The light emitting device may comprise, for example, a singulated LED chip or an LED wafer prior to singulation. As shown in the flow chart of **FIG. 13****,** the light emitting device is heated by one or more heating devices (block **250**). The heating device(s) may include, for example, electrically resistive heating components, inductive heating components and/or combustion-related heating components. In some exemplary embodiments, the light emitting device may be heated and then subsequently processed after the heating operation(s), while in other exemplary embodiments, heating device(s) may be configured to provide heat throughout the subsequently described operations. In some embodiments, the light emitting device may be heated to a temperature in a range of about 90 degrees Celsius to about 155 degrees Celsius,

A recipient luminophoric medium is applied to the heated light emitting device (block **252**). In some embodiments, the recipient luminophoric medium may be applied in the form of a luminescent solution that may be atomized using a flow of pressurized gas. While typically the luminescent solution will comprise a liquid mixture, the term "solution" is used broadly herein to cover any mixture of substances, whether or not such mix is homogeneous and regardless of the form of the substances. The atomized luminescent solution may be sprayed or otherwise deposited onto the heated light emitting device using the flow of pressurized gas. By way of example, the atomized luminescent solution may be sprayed onto the heated light emitting device using an air pressurized spray system. It will be appreciated that the atomized luminescent solution may be applied at different and/or multiple angles, directions and/or orientations.

In some embodiments, the luminescent solution comprises wavelength conversion particles such as phosphor particles that are suspended in a solution that includes a volatile liquid solvent and a binder material. In such embodiments, the volatile liquid solvent may be at least partially evaporated via thermal energy in the heated light emitting device to provide a conformal layer of wavelength conversion particles on the light emitting device. In some embodiments, the luminescent solution may alternatively or additionally include a nonvolatile liquid. In such embodiments, the nonvolatile liquid may be cured via the thermal energy in the heated light emitting device.

In some embodiments, the light emitting device may be a singulated light emitting device that may have a top surface with one or more wirebond pads thereon and/or a bottom surface with one or more wirebond pads thereon.

Respective wires may be bonded to these wirebond pad(s) before heating the light emitting device and before spraying the luminescent solution onto the light emitting device. In other embodiments, the light emitting device may comprise a semiconductor wafer that receives the luminescent solution, and this wafer may thereafter be singulated into a plurality of individual light emitting devices after the recipient luminophoric medium layer is formed thereon.

In some embodiments, multiple layers may be applied to the light emitting device to form the recipient luminophoric medium. These layers may or may not be the same. For example, a first layer may include a first set of at least one luminescent material and a second layer may include a second set of at least one luminescent material, where the first and second sets are different. Since each layer may rapidly cure once it is deposited on the heated light emitting device, subsequent layers may be applied directly thereafter. However, some embodiments provide that the light emitting device may be allowed to cool between layers and then heated again for subsequently applied layers.

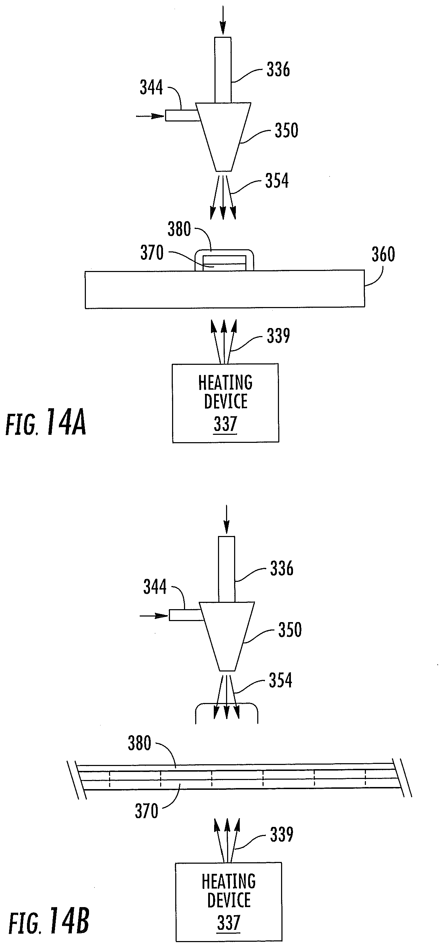

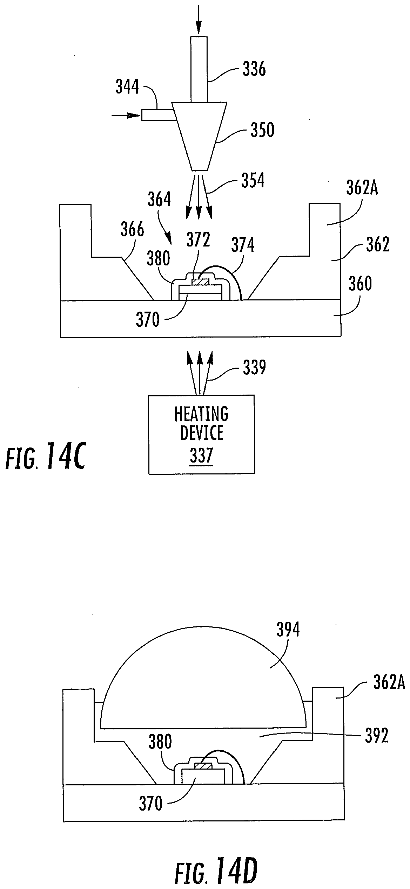

**FIGS. 14A-14L** illustrate operations for applying a luminescent solution **354** to a light emitting device according to further embodiments of the present invention to form a recipient luminophoric medium on the light emitting device. In the embodiments discussed with respect to **FIGS. 14A** and **14C****-14L,** the luminescent solution **354** is applied to a singulated light emitting device **370** (which, in the example of **FIGS. 14A** and **14C****-14L** is illustrated as being an LED chip **370**) that is mounted on a substrate **360.** The substrate **360** may comprise a growth substrate on which the epitaxial layers of the light emitting device **370** were grown and/or a carrier substrate to which the epitaxial layers have been transferred. The luminescent solution **354** may also and/or alternatively be applied to a lens **394** and/or a reflector cup **362** of the LED chip **370,** as will be discussed later herein. The luminescent solution **354** may be applied in a similar manner to, for example, bare (i.e. unmounted) LED die and/or to LED wafers (see **FIG. 14B**).

As shown in **FIG. 14A****,** a heating device **337** may provide heat to the LED chip **370.** Some embodiments provide that a nozzle **350** is configured to spray the luminescent solution **354** onto the heated LED chip **370** to provide a recipient luminophoric medium **380** thereon. The recipient luminophoric medium **380** may be a conformal layer.

As shown in **FIG. 14B****,** the light emitting device **370** may alternatively comprise a wafer **370**' of LED chips which are heated by the heating device **337,** and the luminescent solution **354** may be applied to an exposed surface of the wafer of chips **370**' to provide a conformal recipient luminophoric medium **380** thereon. In the embodiment of **FIG. 14B****,** the wafer **370'** may be singulated after the luminescent solution **354** is applied to provide individual LED chips. In spraying large areas, such as, for example, a wafer, the speed and height of the nozzle **350** may be adjusted to achieve uniform coverage over such areas. Some embodiments provide that an acceleration of the nozzle **350** may be used prior to the application of the luminescent solution **354** to provide uniformity of the conformal layer. In some embodiments, the luminescent solution **354** may be applied to multiple wafers in the same operation(s) to further improve uniformity and/or to reduce waste of the luminescent solution during the acceleration portion. Additionally, by varying process temperatures, a flow time after application may be controlled to achieve desired coverage.

As shown in **FIG. 14C****,** the LED chip **370** may be mounted on a substrate **360.** The LED chip **370** can be mounted on the substrate **360** through an intermediary structure, such as a bonding pad and/or submount (not shown). In some embodiments, the LED chip **370** can be mounted in an optical cavity **364** defined by a reflector cup **362** that is placed on the substrate **360.** The reflector cup **362** includes an angled reflective surface **366** facing the LED chip **370** that is configured to reflect light emitted by the LED chip **370** away from the optical cavity **364.** The reflector cup **362** further includes upwardly extending sidewalls **362A** that define a channel for receiving and holding a lens **94** (see **FIG. 14D**).

The reflector cup **362** is optional. For example, the LED chip **370** could be mounted on a substrate **360,** printed circuit board or other support member without any reflector around the LED chip **370.** Moreover, the reflector cup **362** and the substrate **360** could be merged together as a unitary structure. The substrate **360** could also include a leadframe, and a package body may be formed on the leadframe surrounding the LED chip **370** to define the optical cavity **364.** Likewise, the LED chip **370** could be mounted in any of the exemplary packages discussed above with reference to **FIGS. 8A-11C****.** Accordingly, it will be appreciated that the LED chip **370** could be mounted in many different ways and that the present invention is not limited to any particular packaging configuration.

Still referring to **FIG. 14C****,** the LED chip **370** can include a wirebond pad **372,** and a wirebond connection **374** can be formed from the wirebond pad **372** to a corresponding contact pad (not shown) on the substrate **360** or elsewhere. However, it will be appreciated that the LED chip **370** could be a horizontal LED chip having both anode and cathode contacts on the same side of the chip, and could be mounted in flip-chip fashion on the substrate **360,** so that no bond wire connections need be made to the LED chip in some embodiments.

As shown in **FIG. 14C****,** the luminescent solution **354** may be supplied via a liquid supply line **336** to a spray nozzle **350.** In some embodiments, the luminescent solution **354** may comprise a liquid solvent, a binder and phosphor material. The heating device **337** may apply heat **339** to increase the temperature of the LED chip **370,** the substrate **360,** the reflector cup **362** and the wirebond pad **372.** The luminescent solution **354** in the supply line **336** is sprayed onto the LED chip **370,** forming a thin layer of the atomized binder, solvent and phosphor material thereon that acts as a recipient luminophoric medium **380.** The thermal energy from the heated LED chip **370** and substrate **360** may cause the applied binder, solvent and phosphor to cure rapidly (also referred to herein as "snap-curing"). By snap-curing the applied binder, solvent and phosphor, a substantially uniform and conformal recipient luminophoric medium **380** may be provided on the LED chip **370** and the substrate **360.** The binder material can include a material such as silicone and/or epoxy. Some embodiments provide that the liquid solvent may include a volatile liquid solvent, such as alcohol. The supply line **336** may be purged prior to deposition of the luminescent solution **354.**

The volatile solvent liquid may be evaporated by the thermal energy of the heated substrate **360** and LED chip **370,** leaving the phosphor particles (and perhaps other elements such as diffuser particles that may be in the luminescent solution **354**) in the binder material to provide the conformal recipient luminophoric medium **380.** However, in some cases, a non-volatile liquid, such as silicone and/or epoxy resin, may be used as a carrier liquid for the phosphor/diffuser particles, in which case the non-volatile liquid may be cured by the thermal energy of the heated substrate **360** and LED chip **370** to provide a conformal recipient luminophoric medium **380** on the LED chip **370.**

Referring to **FIG. 14D****,** after spray-coating the LED chip **370** with the conformal layer **380** of binder and phosphor material, an encapsulant material **392,** such as silicone and/or epoxy, can be dispensed to at least partially fill the optical cavity **364,** and a lens **394,** such as a glass or silicone lens, can be positioned over the LED chip **370.** Curing the encapsulant material **392** secures the lens **394** to the structure, and the wall portions **362A** of the reflector cup **362** allow the lens to travel as the encapsulant material **392** expands and contracts with heating/cooling cycles.

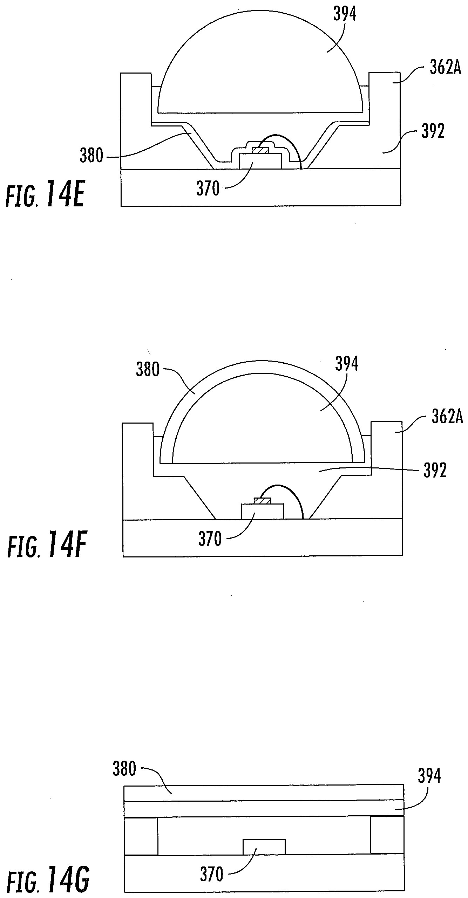

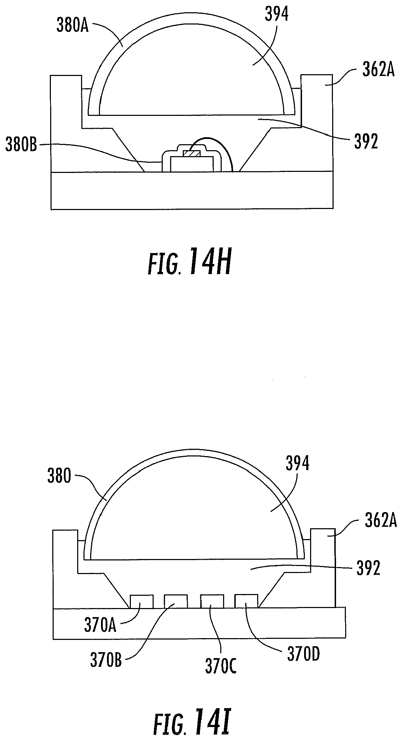

As shown in **FIG. 14E****,** representing an embodiment of the invention as defined by the appended claims, the luminescent solution **354** in the supply line **336** may be sprayed onto the LED chip **370** and the surrounding structure, such as, for example, the reflector cup **362** to form the recipient luminophoric medium **380** thereon. As shown in **FIG. 14F****,** in still other embodiments, the recipient luminophoric medium **380** may be formed on an exterior and/or interior surface of a lens **394,** which is heated to cause the recipient luminophoric medium **380** to cure when applied thereto. As shown in **FIG. 14G****,** in still further embodiments, the recipient luminophoric medium **380** may be applied to a two-dimensional structure, such as, for example, a lens **394** or other transmissive and/or reflective optical element. In other embodiments, multiple of the above-described techniques may be used. By way of example, as shown in **FIG. 14H****,** a first recipient luminophoric medium **380A** may be applied to a heated lens **394** and a second recipient luminophoric medium **380B** may be applied to the heated LED chip **370.**

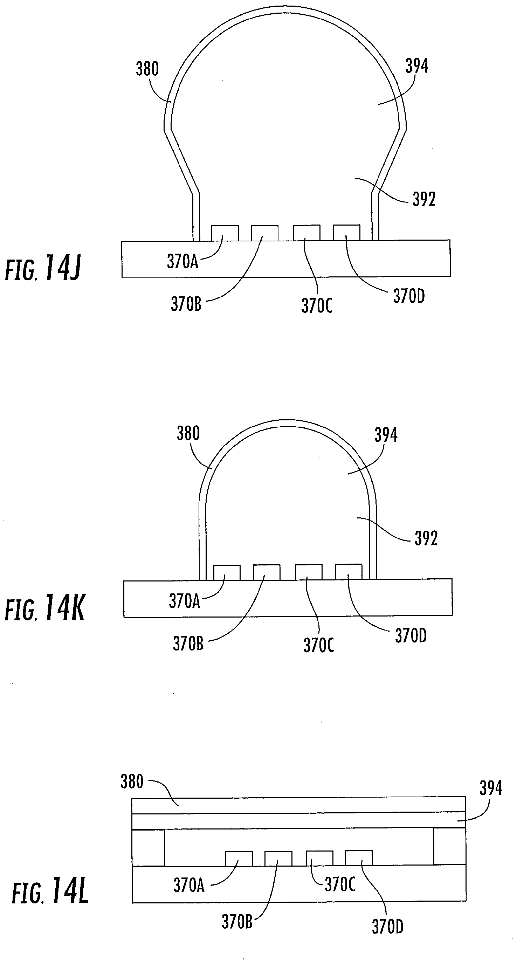

As shown in **FIG. 14I****,** in still further embodiments, recipient luminophoric mediums according to embodiments of the present invention may be formed on a light emitting device that includes multiple LED chips **370A-D.** In some such embodiments, the LED chips **370A-D** may comprise flip-chips that do not have wire bonds for electrical termination but instead are electrically connected to an underlying substrate **360** by, for example, contact pads (not shown). The LED chips **370A-D** may be configured to emit light at one or more different dominant wavelengths and/or combinations thereof. In the embodiment depicted in **FIG. 14I****,** the recipient luminophoric medium **380** is provided on the outside of a lens **394.** **FIGS 14J, 14K** and **14L** illustrate additional exemplary embodiments in which multiple non-wire bonded LED chips **370A-D** are provided inside a lens **394** that includes a recipient luminophoric medium **380** thereon. In still further embodiments, the recipient luminophoric medium **380** may be applied to one or more of the multiple LED chips **370A-D** in addition to or in alternative to the lens **394.** In some embodiments, the LED chips **370A-D** could be wirebonded.

It will be appreciated that the recipient luminophoric medium **380** may be applied to the lens **394** before, during and/or after assembly with the LED chips **370A-D.** For example, some embodiments provide that an array of multiple lenses may be heated and then the luminescent solution **354** is applied thereto. In still other embodiments, the luminescent solution **354** could be sprayed or otherwise deposited in a micro mold to form the recipient luminescent medium **380** which may then be removed from the mold and placed on the light emitting device (e.g., an LED chip **370**).

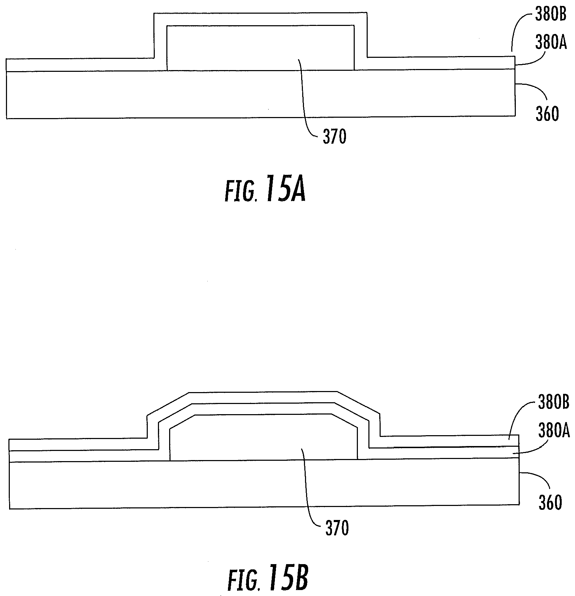

It will also be appreciated that in the various embodiments described herein the recipient luminophoric medium **380** may be formed as a plurality of layers. In such embodiments, the various layers of the recipient luminophoric medium **380** can have the same and/or different luminescent materials (and/or other materials) therein. For example, **FIG. 15A** illustrates an LED chip **370** mounted to a submount or substrate **360** that has a multi-layer recipient luminophoric medium **380** thereon that comprises a first layer **380A** and a second layer **380B.** Additional and/or intervening layers may also be provided. The different layers **380A** and **380B** of the recipient luminophoric medium **380** can include the same or different materials. By way of example, the first layer **380A** may include a first phosphor, and the second layer **380B** may include the first phosphor, a different second phosphor and/or other elements (e.g., diffuser particles). In some embodiments, phosphor particles having different sizes can be in the different layers.

In some embodiments, three layers **380A, 380B, 380C** may be provided. The first layer **380A** may include phosphor particles configured to convert incident light to wavelengths centered about a first peak wavelength (e.g., a peak wavelength in the yellow color range), the second layer **380B** may include phosphor particles configured to convert incident light to wavelengths centered about a second peak wavelength that is in a different color range than the first peak wavelength (e.g., a peak wavelength in the green color range), and the third layer **380C** may include phosphor particles configured to convert incident light to wavelengths centered about a third peak wavelength that is in a different color range than both the first and second peak wavelengths (e.g., a peak wavelength in the red color range). Accordingly, light output by the packaged LED chip **370** can be a mixture of primary light emitted by the LED chip **370** and secondary light emitted by the different phosphors or other luminescent materials included in the layers **380A, 380B** and **380C.** Such light can have improved color rendering properties compared to light generated using only one kind of phosphor.

As shown in **FIG. 15B****,** a recipient luminophoric medium **380** may be applied to an LED chip **370** that includes non-planar surfaces, such as, for example, bevels. The thermal energy from the heated LED chip **370** and substrate **360** may snap-cure the applied binder, solvent and phosphor to provide a substantially uniform and conformal recipient luminophoric medium **380** on the LED chip **370** and the substrate **360.**

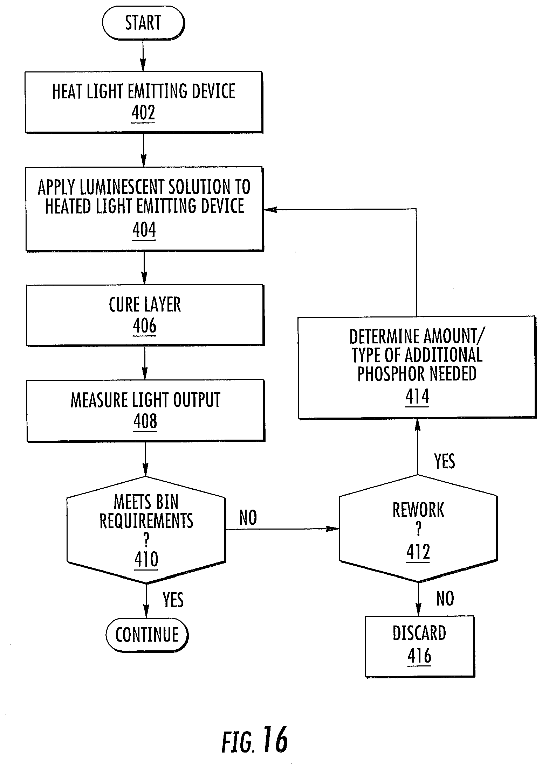

**FIG. 16** is a flowchart of methods of applying one of the recipient luminophoric mediums according to embodiments of the present invention to a light emitting device. As shown in **FIG. 16****,** pursuant to these methods, a light emitting device is heated (block **402**). A luminescent solution that includes, for example, a liquid solvent, binder material and optical materials such as phosphor particles may then be applied to a heated light emitting device using, for example, a spray deposition system according to embodiments of the invention (block **404**). The liquid solvent in the luminescent solution can then be rapidly evaporated and/or cured, depending on whether the solvent is volatile or non-volatile, by virtue of the thermal energy in the heated light emitting device so that binder material can be cured to adhere the optical materials to the light emitting device to form a conformal layer **380A** (block **406**). Some embodiments provide that the light emitting device could then be stored, e.g., at room temperature, to be later retrieved for further tuning.

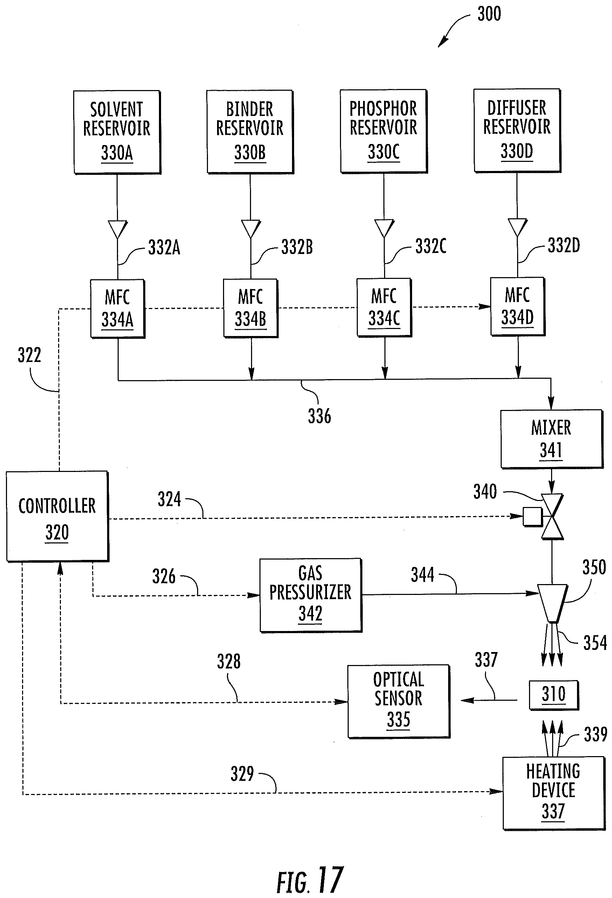

The light emitting device can then be energized, for example, by applying a voltage across anode and cathode terminals of an emitting portion, and one or more optical characteristics of the resulting device, such as output power, color point, and/or correlated color temperature can be measured (block **408**). For example, the light output by the light emitting device can be measured by an optical sensor **335,** and the results can be provided to a controller **320** (see **FIG. 17**). A determination may then be made as to whether or not the optical characteristics of the light emitting device (which may be a singulated LED, an LED wafer, etc.) are acceptable in that, for example, they meet established binning requirements (block **410**). If the optical characteristics of the light emitting device are unacceptable, a decision is made at block **412** whether to discard the device (block **416**) or rework the device. However, if the optical characteristics are satisfactory, the manufacturing process proceeds to the next manufacturing step.

If it is determined that the device can be reworked, the light output corresponding to the light emitting device can be tuned by determining the amount and type of additional phosphor needed to correct the color point/CCT of the structure (block **414**). A second conformal layer **380B** can be applied (block **404**). In some embodiments, the test may be performed while the light emitting device is still heated. The light emitting device may also be heated during the application of the second conformal layer **380B.** The second conformal layer **380B** may include the same and/or different type from the phosphor used in the first conformal layer **380A.** The operations of blocks **404-414** can be repeated multiple times to achieve desired optical characteristics. However, if too much phosphor is applied, the light emission characteristics may deteriorate due to reabsorption and/or excessive absorption of light from the optical element, at which point the light emitting device may fail the test at block **410.**

**FIG. 17** is a schematic diagram illustrating a pressurized deposition system **300** that may be used to coat a light emitting device **310** with a luminescent solution **354** to form a recipient luminophoric medium **380** according to embodiments of the present invention. The light emitting device **310** can be, for example, an LED wafer, a mounted LED die and/or an unmounted (i.e., bare) LED die. In some embodiments, the light emitting device **310** may comprise an LED structure, which may or may not include other structures such as a light transmissive, reflective, and/or support structure, among others.

The system **300** may be used to spray a luminescent solution **354** onto the light emitting device **310.** However, it will be appreciated that in other embodiments the luminescent solution **354** may be applied using other application techniques such as pouring, dipping, rolling, and/or brushing, among others. A heating device **337** applies heat (thermal energy) **339** to the light emitting device **310** to increase the temperature of the light emitting device **310** prior to spraying the luminescent solution **354** thereon. As shown in **FIG. 17****,** a supply line **336** supplies the luminescent solution **354** to a spray nozzle **350,** which sprays the luminescent solution **354** onto the light emitting device **310.** Pressurized gas supplied to the spray nozzle **350** through a high pressure gas supply line **344** atomizes the luminescent solution **354** and directs it towards the light emitting device **310.** The term "atomize" is used herein in a general sense to refer to reducing a liquid to minute particles and/or to a fine spray. The atomized luminescent solution **354** that is deposited on the heated light emitting device **310** may rapidly cure to form a conformal recipient luminophoric medium **380** on the light emitting device **310.** The curing time of the luminescent solution **354** applied to a heated light emitting device **310** may be substantially shorter than that of a luminescent solution **354** that is applied to a non-heated device. As such, settling, separation and/or stratification of the phosphors or other luminescent materials in the recipient luminophoric medium **380** may be reduced. Accordingly, better layer bonding and more uniformity in layer thickness and composition may be achieved.

In some embodiments, the liquid in the supply line **336** may include a binder that includes organic and/or organic-inorganic hybrid materials. The binder material may be, for example, a liquid silicone and/or liquid epoxy, and the volatile or nonvolatile solvent material may be, for example, alcohol, water, acetone, methanol, ethanol, ketone, isopropynol, hydrocarbon solvents, hexane, ethylene glycol, methyl ethyl ketone, xylene, toluene, and combinations thereof. In some embodiments, the binder may have an index of refraction of greater than about 1.25. Some embodiments provide that the index of refraction of a binder material may be greater than about 1.5. It may be desirable to have high light transmission across the visible spectrum. In some embodiments, the binder may have a transmission of light including about 90% or greater in a wavelength range of at least about 440 nm to about 470 nm. In some embodiments, the binder may have a transmission of light including about 95% or greater in a wavelength range of at least about 440 nm to about 470 nm. In some embodiments, the binder may have a transmission of light including about 98% or greater in a wavelength range of at least about 440 nm to about 470 nm. In some embodiments, the binder may have a transmission of light of at least about 90% or greater, about 95% or greater, and/or about 98% or greater for other wavelengths in the visible spectrum, such as green, yellow and/or red. In general, a volatile solvent may dry or evaporate off shortly after being deposited. A volatile or nonvolatile solvent material can include particles therein that are to be deposited onto the LED structure, such as particles of a luminescent material (e.g., a phosphor) and/or particles of a light-scattering material, such as titanium dioxide, among others. The liquid in the supply line **336** may be provided from one of a plurality of fluid reservoirs **330A-D,** which are attached to the supply line **336** through respective input lines **332A-D.** The flow of liquid through the input lines **332A-D** can be controlled by electronically-controlled mass flow controllers **334A-D,** respectively.

As shown in **FIG. 17****,** the reservoirs **330A-D** can include a solvent reservoir **330A** that contains a volatile liquid solvent, such as alcohol, water, etc., and a binder reservoir **330B** that contains a liquid binder material, such as liquid silicone and/or liquid epoxy. In some embodiments, the solvent reservoir **330A** and the binder reservoir **330B** can include "pure" liquids, that is, liquids that do not contain any phosphor, diffuser, or other particles therein. The reservoirs **330A-D** can also include a phosphor reservoir **330C** that contains a liquid solvent in which a concentration of phosphor particles is suspended. In some embodiments, the phosphor reservoir **330C** can include phosphor particles at a concentration that is greater than a concentration at which the phosphor particles will be applied onto the light emitting device **310.**

In some embodiments, the reservoirs **330A-D** can also include a diffuser reservoir **330D** that contains a liquid solvent in which a concentration of diffuser particles is suspended. In some embodiments, the diffuser reservoir **330D** can include diffuser particles at a concentration that is greater than a concentration at which the diffuser particles will be applied onto the optical element **310.**

One or more of the reservoirs **330A-D** can be pressurized, so that flow from the reservoirs **330A-D** can be obtained by positive pressure into the supply line **363.** In particular, the solvent reservoir **330A** and the binder reservoir **330B** can be pressurized. In some embodiments, the phosphor reservoir **330C** and/or the diffuser reservoir **330D** may not be pressurized, so that flow from the phosphor reservoir **330C** and/or the diffuser reservoir **330D** may be induced into the supply line **336** by negative pressure caused by flow through the supply line **336.** In some embodiments, the pressure in the liquid supply line **336** need not be high, since the force for spraying the liquid onto the optical element **310** may be provided by a high-pressure gas line **344.**

The flow of liquid through the supply line **336** can be controlled by an electronically controllable valve **340.** When the valve **340** is open, liquid in the supply line **336** is supplied to the spray nozzle **350**.

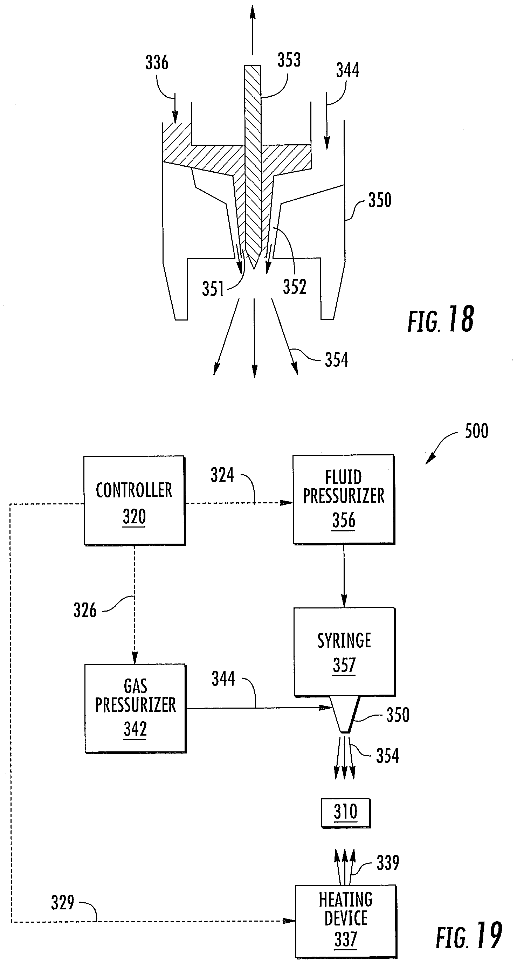

**FIG. 18** illustrates a spray nozzle **350** in greater detail. Referring to **FIGS. 17** and **18****,** pressurized gas (e.g., pressurized air) generated by a gas pressurizer **342** may be supplied to the spray nozzle **350** through the pressurized gas supply line **344**. The pressurized gas is directed to through a gas outlet port **352** in the spray nozzle **350** that is adjacent a liquid outlet port **351.** The flow of liquid through the liquid outlet port **351** can be regulated, for example, by controlling the position of a retractable pin **353.** When the pin **353** is retracted, the liquid outlet port **351** is opened. The flow of pressurized gas out of the gas outlet port **352** creates a negative pressure gradient relative to the liquid outlet port **351,** which causes liquid dispensed from the liquid outlet port **351** to be atomized. The atomized luminescent solution **354** is then sprayed by the gas flow from the gas outlet port **352** onto the light emitting device **310.**

As further illustrated in **FIG. 17****,** operations of the mass flow controllers **334A-D,** the electronically controllable flow valve **340,** and the gas pressurizer **342** can be controlled by a controller **320** via electronic control lines **322, 324, 326.** The controller **320** can be a conventional programmable controller and/or can include an application specific integrated circuit (ASIC) configured to control operation of the respective elements of the system **300,** or a general microprocessor or controller (e.g. computer).

Referring still to **FIG. 17****,** by controlling the operations of the mass flow controllers (MFCs) **334A-D** and the valve **340,** the controller **320** can control the composition of liquid that is supplied to the spray nozzle **350** through the supply line **336.** In particular, the controller **320** can cause the MFCs **330A, 330C** and **330D** to turn off, while the MFC **330B** and the valve **340** are turned on, to thereby supply the binder liquid to the spray nozzle **350.** Likewise, the controller **320** can cause the MFCs **330B, 330C** and **330D** to turn off, while the MFC **330A** and the valve **340** are turned on, to thereby supply only the solvent liquid to the spray nozzle **350.** With the solvent material from the solvent reservoir **330A** flowing, the controller **320** can cause the MFCs **334C** and/or **334D** to release liquids bearing phosphor particles (in the case of the phosphor reservoir **330C**) and/or diffuser particles (in the case of the diffuser reservoir **330D**) into the flow in the supply line **336.** Accordingly, the controller **320** can precisely control the composition of material sprayed onto the light emitting device **310** by the spray nozzle **350.**

It will be appreciated that while **FIG. 17** illustrates a single phosphor reservoir **330C** and a single diffuser reservoir **330D,** more reservoirs can be provided and attached to the supply line through respective MFCs and/or supply valves that can be electronically controlled by the controller **320.** For example, separate phosphor reservoirs can be provided for red phosphors, green phosphors, yellow phosphors, blue phosphors, etc., depending on the product requirements. Some embodiments provide that more than one color of phosphor may be applied to a light emitting device **310** in respectively separate regions and/or mixed to form a single layer. Furthermore, more than one type of diffuser particle can be selectively provided using different diffuser reservoirs. For example, it may be desirable to apply diffuser particles having a first composition and/or diameter on one part of a light emitting device **310** and diffuser particles having a different composition and/or diameter on another part of the light emitting device **310.** It may be desirable to apply more than one phosphor (e.g., different colors) in discrete areas of the LED structure. It may also be desirable to mix differently colored phosphors in a single layer, region and/or area of the LED structure (similar to **FIG. 15A****,** except different colored phosphors are within a single layer). In such cases, there may be at least two different phosphors applied at the same time, either from separate reservoirs or a single reservoir that contains multiple phosphors.

As illustrated, the heating device **337** applies heat **339** to the light emitting device **310** to increase the temperature of the light emitting device **310** prior to spraying the luminescent solution **354** thereon. Some embodiments provide that the heating device **337** may be electronically controlled by the controller **320** via electronic control line **329.** In some embodiments, the heating device **337** may apply heat **339** to the light emitting device **310** during the spraying operation(s). In some embodiments, the heating device **337** may be used to heat the light emitting device **310** prior to the spraying operation(s) and/or may be operated independent of the controller **320.**

Some embodiments provide that the heating device **337** includes a thermally conductive heating surface through which heat **339** is transferred to the light emitting device **310**. In some embodiments, the heating device **337** may use a heat transfer media, such as, for example, heated air and/or gases, to transfer heat **339** to the light emitting device **310.** Embodiments of the heating device may include electrically resistive and/or conductive and/or combustion related heat generating elements.

Some embodiments provide that the light emitting device **310** is heated to greater than 70 degrees Celsius. Some embodiments provide that the light emitting device **310** is heated to greater than 90 degrees Celsius. Some embodiments provide that the light emitting device **310** is heated to greater than 120 degrees Celsius. In some embodiments, the light emitting device **310** is heated to a temperature in a range of about 70 degrees Celsius to about 155 degrees Celsius. In some embodiments, the light emitting device **310** is heated to a temperature in a range of about 90 degrees Celsius to about 155 degrees Celsius. In some embodiments, the light emitting device **310** is heated to a temperature in a range of about 90 degrees Celsius to about 120 degrees Celsius. In some embodiments, the light emitting device **310** is heated to a temperature in a range of about 90 degrees Celsius to about 155 degrees Celsius. When the atomized luminescent solution **354** is deposited on the light emitting device **310,** the thermal energy in the heated light emitting device **310** may rapidly cure and/or evaporate the solvent portion of the atomized luminescent solution **354.** By rapidly curing and/or evaporating the solvent, settling and/or redistribution of the luminescent materials prior to curing may be reduced. In this regard, a more uniform concentration of the luminescent materials within the applied layer may be preserved, thus providing a substantially conformal layer on the light emitting device **310.**

It will be further appreciated that a system **300** as illustrated in **FIG. 17** may be split into several parts. For example, the system **300** could be modified to have a first supply line **336** and nozzle **350** dedicated to spray-applying an atomized luminescent solution **354** from a first direction and/or at a first angle relative to the light emitting device **310** and a second supply line **336** and nozzle **350** dedicated to spray-applying an atomized luminescent solution **354** from a second different direction and/or at a second different angle relative to the light emitting device **310.** Some embodiments provide that the first and second supply lines **336** and nozzles **350** are configured to provide the same atomized luminescent solution **354.** In some embodiments, the first and second supply lines **336** and nozzles **350** are configured to provide different atomized luminescent solutions **354**. Accordingly, many different combinations of reservoirs, supply lines and spray nozzles are contemplated according to various embodiments.

A mixer **341** may be provided to mix supply line **336** constituents from various different ones of the reservoirs **330A-D.** In some embodiments, the mixer **341** may include a static mixing element that causes the materials in the supply line **336** to mix by virtue of the flow therethrough. In other embodiments, an active mixing element may be provided that agitates the supply line **336** materials to keep particles in suspension and/or substantially uniformly distributed throughout the materials. Although not illustrated, pressure controllers may be provided for various ones of the components. For example, the reservoirs **330A-D** and the nozzles **350** may include pressure controllers to provide control over the supply and/or delivery pressures, among others. Further, some embodiments may include static and/or active mixing elements in the reservoirs **330A-D.** For example, the phosphor reservoir **330C** and the diffuser reservoir **330D** may use mixing elements to maintain the particles in suspension.

As is further shown in **FIG. 17****,** an optical sensor **335** may be provided that is configured to sense light **337** emitted by the light emitting device **310.** For example, the optical sensor **335** can detect a color point and/or intensity of light emitted by the light emitting device **310.** The detected light information can be provided to the controller **330** via a communication line **328,** and can be used as a feedback signal in the control of the operations of the deposition system **300,** as described in more detail herein.

Reference is now made to **FIG. 19****,** which is a schematic diagram illustrating a batch deposition system **500** for coating a light emitting device with a luminescent solution, according to some embodiments of the invention. As shown in **FIGS. 18** and **19****,** pressurized gas (e.g., pressurized air) generated by a gas pressurizer **342** may be supplied to a spray nozzle **350** through a pressurized gas supply line **344.** The pressurized gas is directed to through a gas outlet port **352** in the spray nozzle **350** that is adjacent a liquid outlet port **351.** The flow of liquid through the liquid outlet port **351** can be regulated, for example, by controlling the position of a retractable pin **353.**

A syringe **357** may be provided that includes a luminescent solution **354.** The luminescent solution **354** may include, for example, one or more types of phosphor particles, one or more types of diffuser particles, a binder, and/or one or more solvents. The syringe **357** may be loaded with the luminescent solution **354** using, for example, a cartridge, shortly before the application operations to reduce settling and/or stratification of the components therein. In some embodiments, the syringe **357** may be coupled directly and/or closely to the nozzle **350** to reduce settling of suspended particles in the luminescent solution **354.** Some embodiments provide that lateral fluid paths may be reduced and/or avoided as such paths may result in settling and/or stratification of the luminescent materials in the luminescent solution **354.** In some embodiments, an active and/or static mixing element is provided with and/or within the syringe **357** to reduce settling.

A fluid pressurizer **356** may be provided to provide and/or control a fluid pressure within the syringe **357.** Some embodiments provide that the fluid pressure may be substantially lower than the gas pressure provided by the gas pressurizer **342.**

As further illustrated in **FIG. 19****,** operations of the gas pressurizer **342,** the fluid pressurizer **356** and the heating device **337** can be controlled by a controller **320** via electronic control lines **324, 326** and **329.** The controller **320** can be a conventional programmable controller and/or can include an application specific integrated circuit (ASIC) configured to control operation of the respective elements of the system **500,** or a general microprocessor or controller (e.g. computer). By controlling the operations of the fluid pressurizer **356** and the gas pressurizer **342,** the controller **320** can control the flow of liquid that is supplied to the spray nozzle **350.**

It will be appreciated that while **FIG. 19** illustrates a single syringe **357** and nozzle **350,** more syringes **357** and nozzles **350** can be provided and attached to gas pressurizer **342** and the fluid pressurizer **356**. In some embodiments, additional gas pressurizers **342** and fluid pressurizers **356** may be electronically controlled by the controller **320.**

As illustrated, the heating device **337** applies heat **339** to the light emitting device **310** to increase the temperature thereof before the luminescent solution **354** is sprayed onto the light emitting device **310.** Some embodiments provide that the heating device **337** may be electronically controlled by the controller **320** via electronic control line **329.** In some embodiments, the heating device **337** may apply heat **339** to the light emitting device **310** during the spraying operation(s). In some embodiments, the heating device **337** may be used to heat the light emitting device **310** prior to the spraying operation(s) and/or may be operated independent of the controller **320.**

Some embodiments provide that the heating device **337** includes a thermally conductive heating surface through which heat **339** is transferred to the light emitting device **310.** In some embodiments, the heating device **337** may use a heat transfer media, such as, for example, heated air and/or gases, to transfer heat **339** to the light emitting device **310.** Embodiments of the heating device **337** may include electrically resistive and/or conductive and/or combustion related heat generating elements.

It will be further appreciated that a system **500** as illustrated in **FIG. 19** may be split into several parts, so that, for example, separate syringes **357** are provided and/or separate spray nozzles **350** are provided. Accordingly, many different combinations of syringes **357,** nozzles **350,** fluid pressurizers **356** and/or gas pressurizers **342** are contemplated according to various embodiments.

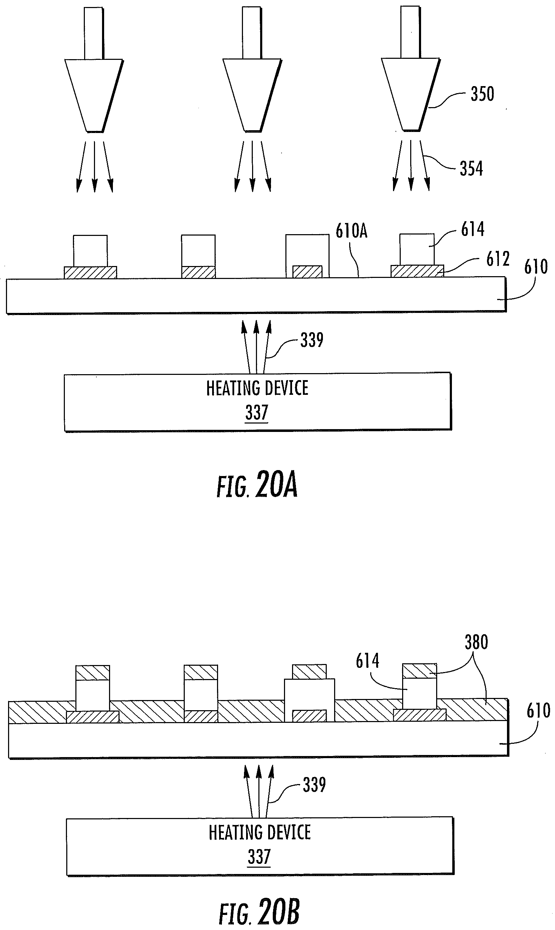

**FIGS. 20A-C** illustrate operations associated with coating a wafer such as an LED wafer according to some embodiments. Referring to **FIG. 20A** an LED wafer **610** is provided that includes a plurality of thin epitaxial layers that define a light emitting diode structure. The epitaxial layers may be supported by a growth substrate and/or a carrier substrate. The epitaxial region of the LED wafer **610** can be divided into a plurality of discrete device regions, for example, by mesa and/or implant isolation. In some embodiments, dicing streets (i.e., linear regions where the wafer is to be diced using a dicing saw) and/or scribe lines may already be formed in the LED wafer **610.** A plurality of electrical contacts **612** are formed on the LED wafer **610.** In particular, each discrete device in the LED wafer **610** can include at least one electrical contact **612** on a side of the wafer on which a recipient luminophoric medium is to be applied.

A sacrificial pattern **614** is formed on the electrical contacts **612.** The sacrificial pattern **614** can include a material such as soluble polymer and/or glass, which can be applied and patterned using conventional photolithographic techniques. The sacrificial pattern **614** can be aligned with the underlying electrical contacts **612.** Alternatively, the sacrificial pattern **614** may only cover portions of the electrical contacts **612,** with some portions of the electrical contacts **612** being exposed. In some embodiments, the sacrificial pattern **614** can be wider than the electrical contacts **612,** so that portions of the surface **610A** of the LED wafer **610** adjacent the electrical contacts are also covered by the sacrificial patterns. Each of these configurations is illustrated in **FIG. 20A****.**

Referring still to **FIGS. 20A** and **20B****,** the LED wafer **610** is heated using a heating device **337** and one or more conformal layers of a recipient luminophoric medium **380** are applied to the surface **610A** of the LED wafer **610** using, for example, a pressurized deposition system according to embodiments of the present invention. The recipient luminophoric medium **380** is coated onto the surface **610A** of the LED wafer **610** and on the sacrificial pattern **614.** In some embodiments, the recipient luminophoric medium **380** may also be coated onto upper portions of the electrical contacts **612** opposite the LED wafer **610.**

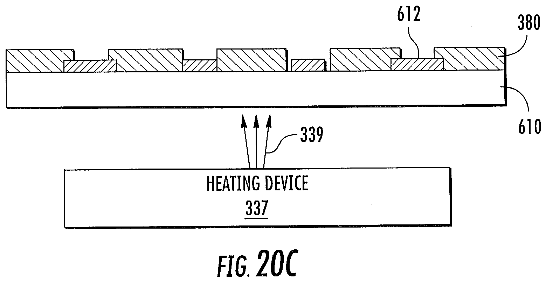

After spray-coating the LED wafer **610,** the sacrificial pattern **614** can be removed, for example, by exposure to a liquid solvent specific to the sacrificial pattern material, resulting in an LED wafer **610** as shown in **FIG. 20C** that includes exposed electrical contacts **612** and a recipient luminophoric medium **380** on the surface of the LED wafer **610.** Although not specifically illustrated, some embodiments provide that the sacrificial pattern **614** may be formed using a film and/or tape that may be removed after the LED wafer is spray coated.

According to still further embodiments of the present invention, the recipient luminophoric medium **380** may be coated onto individual singulated light emitting devices **310.** For example, pursuant to one such exemplary method, a light emitting device may be mounted on a reflective cup by means of a solder bond or conductive epoxy, and an encapsulant material such as, for example, silicone that has the phosphors suspended therein, may be used as the recipient luminophoric medium. This recipient luminophoric medium may be used, for example, to partially or completely fill the reflective cup.

While exemplary methods of applying a recipient luminophoric medium 380 and otherwise fabricating the light emitting devices according to embodiments of the present invention have been discussed above, it will be appreciated that that numerous other fabrication methods are available. For example, U.S. Patent Application Serial No. 11/899,790, filed September 7, 2007, discloses various additional methods of coating a recipient luminophoric medium onto a solid state light emitting device.

It is understood that although the present invention has been described with respect to LEDs having vertical geometries, it may also be applied to LEDs having other geometries such as, for example, to lateral LEDs that have both contacts on the same side of the LED chip.

While embodiments of the present invention have primarily been discussed above with respect to solid state light emitting devices that include LEDs, it will be appreciated that according to further embodiments of the present invention, laser diodes and/or other solid state lighting devices may be provided that include the luminophoric mediums discussed above. Thus, it will be appreciated that embodiments of the present invention are not limited to LEDs, but may include other solid state lighting devices such as laser diodes.

In the drawings and specification, there have been disclosed embodiments of the invention and, although specific terms are employed, they are used in a generic and descriptive sense only and not for purposes of limitation, the scope of the invention being defined by the appended claims.

## Claims

1. A light emitting device, comprising:
a submount (360) having at least one reflective portion (362);
a solid state lighting source (370) on the submount;
a conformal recipient luminophoric medium (380) for down-converting at least some of the radiation emitted by the solid state lighting source,
wherein the recipient luminophoric medium extends conformally on the solid state lighting source and on the at least one reflective portion of the submount,
the luminophoric medium including a first material that down-converts the radiation emitted by the solid state lighting source to radiation having a peak wavelength in the green color range that has a full width half maximum emission bandwidth that extends into the cyan color range, and at least one additional material that down-converts the radiation emitted by the solid state lighting source to radiation having a peak wavelength in another color range,
wherein the first material comprises a first phosphor that down-converts the radiation emitted by the solid state lighting source to a radiation having a peak wavelength between 525 nanometers and 550 nanometers, and has a full width half maximum emission bandwidth that extends below 500 nanometers,
**characterised in that**
the at least one additional material that down-converts the radiation emitted by the solid state lighting source to a radiation having a peak wavelength in another color range comprises a second phosphor and a third phosphor which together down-convert the radiation emitted by the solid state lighting source to a radiation having a peak wavelength greater than 580 nanometers, and
wherein the first phosphor comprises a LuAG:Ce phosphor, the second phosphor comprises a YAG:Ce phosphor, and the third phosphor comprises a (Ca₁₋ₓSrₓ)SiAlN₃:Eu²⁺ phosphor.

2. The light emitting device of Claim 1, wherein the light emitted by the light emitting device has a color point that is within 7 MacAdam ellipses of the black-body locus on a 1931 CIE chromaticity diagram, a CRI value of at least 90 and a correlated color temperature of between 2500K and 3300K.

3. The light emitting device of Claim 1, wherein the ratio of the first phosphor to the second phosphor is between 1:3 and 3:1 by weight.

4. The light emitting device of Claim 1, wherein the solid state lighting source is mounted on a mounting surface such that light emission occurs through a substrate of the solid state lighting source.

5. The light emitting device of Claim 1, wherein an anode contact and a cathode contact of the solid state lighting source are both on the same side of the solid state lighting source.

## Patentansprüche

1. Licht emittierende Vorrichtung, umfassend:
einen Unterbau (360), welcher wenigstens einen reflektierenden Abschnitt (362) aufweist;
eine Feststoff-Lichtquelle (370) an dem Unterbau;
ein konformes luminophorisches Aufnahmemedium (380) für eine Abwärtskonvertierung von wenigstens mancher der Strahlung, welche durch die Feststoff-Lichtquelle emittiert wird, wobei sich das luminophorische Aufnahmemedium an der Feststoff-Lichtquelle und an wenigstens einem reflektierenden Abschnitt des Unterbaus konform erstreckt,
wobei das luminophorische Aufnahmemedium ein erstes Material,
welches die Strahlung, welche durch die Feststoff-Lichtquelle emittiert wird, zu einer Strahlung abwärts konvertiert, welche eine Spitzenwellenlänge in dem grünen Farbbereich aufweist, welche eine Vollbreiten-Halbmaximums-Emissionsbandbreite aufweist, welche sich in den Cyan-Farbbereich erstreckt, und wenigstens ein zusätzliches Material umfasst, welches die Strahlung, welche durch die Feststoff-Lichtquelle emittiert wird, zu einer Strahlung abwärts konvertiert, welche eine Spitzenwellenlänge in einem anderen Farbbereich aufweist, wobei das erste Material einen ersten Phosphor umfasst, welcher die Strahlung, welche durch die Feststoff-Lichtquelle emittiert wird, zu einer Strahlung abwärts konvertiert, welche eine Spitzenwellenlänge zwischen 525 nm und 550 nm aufweist, und eine Vollbreiten-Halbmaximums-Emissionsbandbreite aufweist, welche sich unter 500 nm erstreckt,
**dadurch gekennzeichnet, dass**
das wenigstens eine zusätzliche Material, welches die Strahlung,
welche durch die Feststoff-Lichtquelle emittiert wird, zu einer Strahlung abwärts konvertiert, welche eine Spitzenwellenlänge in einem anderen Farbbereich aufweist, einen zweiten Phosphor und einen dritten Phosphor umfasst, welche zusammen die Strahlung, welche durch die Feststoff-Lichtquelle emittiert wird, zu einer Strahlung abwärts konvertieren, welche eine Spitzenwellenlänge aufweist, welche größer als 580 nm ist, und
wobei der erste Phosphor einen LuAG:Ce-Phosphor, der zweite Phosphor einen YAG:Ce-Phosphor und der dritte Phosphor einen (Ca₁₋ₓ Srₓ)SiAlN₃:Eu²⁺-Phosphor umfasst.

2. Licht emittierende Vorrichtung nach Anspruch 1, wobei das Licht, welches durch die Licht emittierende Vorrichtung emittiert wird, einen Farbpunkt aufweist, welcher innerhalb von 7 MacAdam-Ellipsen des Schwarzkörperorts in einem 1931 CIE Chromatizitäts-Diagramm, ein CRI-Wert von wenigstens 90 und eine korrelierte Farbtemperatur von zwischen 2500 K und 3300 K ist.

3. Licht emittierende Vorrichtung nach Anspruch 1, wobei das Gewichtsverhältnis des ersten Phosphors zu dem zweiten Phosphor zwischen 1:3 und 3:1 beträgt.

4. Licht emittierende Vorrichtung nach Anspruch 1, wobei die Feststoff-Lichtquelle derart an einer Montagefläche angebracht ist, dass eine Lichtemission durch ein Substrat der Feststoff-Lichtquelle auftritt.

5. Licht emittierende Vorrichtung nach Anspruch 1, wobei ein Anodenkontakt und ein Kathodenkontakt der Feststoff-Lichtquelle beide an der gleichen Seite der Feststoff-Lichtquelle sind.

## Revendications

1. Dispositif électroluminescent, comprenant :
une embase (360) ayant au moins une partie réfléchissante (362) ;
une source d'éclairage à semi-conducteur (370) sur l'embase ;
un milieu luminophore récepteur conforme (380) pour convertir par abaissement de fréquence au moins une partie du rayonnement émis par la source d'éclairage à semi-conducteur,
dans lequel le milieu luminophore récepteur s'étend de manière conforme sur la source d'éclairage à semi-conducteur et sur l'au moins une partie réfléchissante de l'embase,
le milieu luminophore comportant un premier matériau qui convertit par abaissement de fréquence le rayonnement émis par la source d'éclairage à semi-conducteur en un rayonnement ayant une longueur d'onde de crête dans la gamme de couleurs vertes qui a une largeur à mi-hauteur de la largeur de bande d'émission qui s'étend dans la gamme de couleurs cyan, et au moins un matériau supplémentaire qui convertit par abaissement de fréquence le rayonnement émis par la source d'éclairage à semi-conducteur en un rayonnement ayant une longueur d'onde de crête dans une autre gamme de couleurs,
dans lequel le premier matériau comprend un premier luminophore qui convertit par abaissement de fréquence le rayonnement émis par la source d'éclairage à semi-conducteur en un rayonnement ayant une longueur d'onde de crête comprise entre 525 nanomètres et 550 nanomètres, et présente une largeur à mi-hauteur de la largeur de bande d'émission qui s'étend en dessous de 500 nanomètres,
**caractérisé en ce que**
l'au moins un matériau supplémentaire qui convertit par abaissement de fréquence le rayonnement émis par la source d'éclairage à semi-conducteur en un rayonnement ayant une longueur d'onde de crête dans une autre gamme de couleurs comprend un deuxième luminophore et un troisième luminophore qui, ensemble, convertissent par abaissement de fréquence le rayonnement émis par la source d'éclairage à semi-conducteur en un rayonnement ayant une longueur d'onde de crête supérieure à 580 nanomètres, et
dans lequel le premier luminophore comprend un luminophore LuAG:Ce, le deuxième luminophore comprend un luminophore YAG:Ce, et le troisième luminophore comprend un luminophore (Ca₁₋ₓSrₓ)SiAlN₃:Eu²⁺.

2. Dispositif électroluminescent de la revendication 1, dans lequel la lumière émise par le dispositif électroluminescent a un point de couleur qui se trouve à l'intérieur de 7 ellipses de MacAdam du lieu du corps noir sur un diagramme de chromaticité CIE 1931, une valeur CRI d'au moins 90 et une température de couleur corrélée comprise entre 2500k et 3300k.

3. Dispositif électroluminescent de la revendication 1, dans lequel le rapport du premier luminophore sur le deuxième luminophore est compris entre 1:3 et 3:1 en poids.

4. Dispositif électroluminescent de la revendication 1, dans lequel la source d'éclairage à semi-conducteur est montée sur une surface de montage de sorte qu'une émission de lumière se produise à travers un substrat de la source d'éclairage à semi-conducteur.

5. Dispositif électroluminescent de la revendication 1, dans lequel un contact d'anode et un contact de cathode de la source d'éclairage à semi-conducteur sont tous deux sur le même côté de la source d'éclairage à semi-conducteur.
